# FASCICULE DE BREVET EUROPEEN

(11) **EP 0 336 830 B1**
(45) Date de publication et mention de la délivrance du brevet: **10.08.1994**
(21) Numéro de dépôt: 89400916.6
(22) Date de dépôt: 04.04.1989
(51) Int. Cl.: H01L 21/20, H01L 21/76

(54) **Procédé de réalisation d'une alternance de couches de matériau semiconducteur monocristallin et de couches de matériau isolant**
Verfahren zur Herstellung einer alternierenden Folge monokristalliner Halbleiterschichten und Isolierschichten
Method for producing an alternance of monocrystalline semiconductor layers and insulating layers

(30) Priorité: 05.04.1988 FR 8804437
(43) Date de publication de la demande: 11.10.1989
(73) Titulaire: THOMSON-CSF, 75008 Paris (FR)
(72) Inventeur: Pribat, Didier, F-92045 Paris la Defense (FR); Karapiperis, Leonidas, F-92045 Paris la Defense (FR); Collet, Christian, F-92045 Paris la Defense (FR); Garry, Guy, F-92045 Paris la Defense (FR)
(74) Mandataire: Grynwald, Albert

(56) Documents cités:
- WO-A-87/04854
- DE-B- 1 639 581
- US-A- 4 725 112
- JOURNAL OF APPLIED PHYSICS, vol. 55, no. 2, 15 janvier 1984, pages 519-523, American Institute of Physics, Woodbury, NY, US; D.R. BRADBURY et al.: "Control of lateral epitaxial chemical vapor deposition of silicon over insulators"
- JOURNAL OF CRYSTAL GROWTH, vol. 73, 1985, pages 73-76, Elsevier Science Publishers B.V. (North-Holland Physics Publishing Division), Amsterdam, NL; K. KAMON et al.: "Selective epitaxial growth of GaAs by low-pressure MOVPE"
- PROCEEDINGS OF THE 4TH ANNUAL ESPRIT CONFERENCE, septembre 1987, pages 55-71; D. CHAPUIS et al.: "SOI materials and processing towards 3D integration"
- EXTENDED ABSTRACTS OF THE 18TH (1986 INTERNATIONAL) CONFERENCE ON SOLID STATE DEVICES AND MATERIALS, Tokyo, 1986, pages 713-714; L. KARAPIPERIS et al.: "Selective epitaxial growth of Si and in situ deposition of amorphous- orpoly-Si for recrystallisation purposes"

## Description

L'invention concerne un procédé de réalisation d'une alternance de couches de matériau semiconducteur monocristallin et de couches de matériau isolant, plus particulièrement un procédé de réalisation d'au moins une couche mince d'un matériau semiconducteur sur une couche d'isolant elle même déposée sur une couche de substrat monocristallin.

L'invention a pour but d'obtenir l'intégration à trois dimensions de composants électroniques actifs. Elle permet ainsi de réaliser à partir d'un substrat semiconducteur monocristallin (silicium monocristallin par exemple), un empilement de couches minces de semiconducteur monocristallin, chaque couche étant isolée de la précédente par une couche d'isolant telle que, par exemple, une couche de silice ou de diélectrique approprié dans le cas de couches en silicium monocristallin.

On connaît dans la technique, des structures de silicium monocristallin sur isolant (SOI pour Silicon On Insulator en terminologie anglo-saxonne) à un seul niveau. Cependant dans ces structures, aucune contrainte thermique n'est imposée lors de la réalisation de la seule couche de silicium sur isolant.

On connaît aussi des dispositifs à plusieurs couches de silicium monocristallin sur isolant mais dans ce cas, il faut que lors du dépôt et de la recristallisation de la couche semiconductrice numéro j, la couche j-1 déjà réalisée et processée ne soit pas affectée thermiquement, ce qui impose une contrainte supplémentaire.

Pour la réalisation de ces couches de silicium monocristallin sur isolant différentes techniques sont disponibles telles que :
a) la technique d'hétéroépitaxie de silicium sur saphir (SOS ou Silicon On Saphire) ;
b) la technique dite SIMOX qui consiste en la formation d'une couche de SiO₂ enterrée dans du silicium monocristallin par implantation d'oxygène à très forte dose ;
c) la technique dite FIPOS qui consiste en la formation de SiO₂ enterrée par oxydation du silicium poreux ;
d) les méthodes par recristallisation de couches de silicium amorphe ou polycristallin, soit en phase solide, soit après fusion (par lampes ou par faisceau laser ou par faisceau d'électrons) ;
e) la méthode d'épitaxie latérale de silicium sur isolant (méthode ELO ou Epitaxial Lateral Overgrowth) par dépôt en phase vapeur CVD (Chemical Vapor Deposition).

Les trois premières méthodes (a, b, et c) permettent de réaliser des dispositifs dans une structure à un seul niveau de semiconducteur monocristallin mais ne permettent pas de réaliser les dispositifs à trois dimensions parce qu'il faut trop chauffer pour réaliser les niveaux supérieurs et/ou pour supprimer les défauts et on risque alors de détériorer les dispositifs dans les couches de semiconducteur monocristallin sous jascentes.

De toutes ces méthodes, ce sont les deux dernières (d et e) qui se prêtent en principe le mieux à l'intégration des circuits actifs en trois dimensions, d'une part grâce à la facilité relative de répéter la formation des couches de silicium sur isolant sur plusieurs niveaux successifs, d'autre part, grâce à la compatibilité thermique qui permet potentiellement de former une couche monocristalline sans détériorer les dispositifs dans la couche inférieure, à l'exception toutefois de la méthode de fusion par lampes qui n'est que peu localisée en comparaison des méthodes par faisceau laser ou faisceau d'électrons.

Toutefois, la recristallisation par fusion par faisceau laser ou par faisceaux d'électrons pose des problèmes délicats de contrôle de l'échauffement excessif des couches sous-jacentes dans lesquelles des dispositifs ont été déjà réalisés.

On trouvera un état de ces techniques dans le document "SOI Materials and Processing Towards 3D Integration" de D.CHAPUIS et Coll publié dans Proceedings of the 4th Annual ESPRIT conférence, Septembre 1987, page 55.

La technique par épitaxie en phase vapeur (CVD) est en principe plus adaptée du point de vue thermique à la réalisation de structures à trois dimensions parce que la croissance monocristalline peut s'effectuer à des températures aussi basses que 850°-900°C. Une telle technique est décrite dans le document "Advanced Dielectric Isolation Through Selective Epitaxial Growth Techniques" de J.O. BORLAND et C.I. DROWLEY publié dans Solid State Technology, Août 1985, page 141 ainsi que dans le document "Sélective Epitaxial Growth of Si and in-situ Deposition of Amorphous or Poly-Si for Recrystallisation Purposes", de L. KARAPIPERIS et Coll. Publié dans Proceedings, 18th Intl. Conference on Solid State Devices and Materials, TOKYO 1986, page 713".

L'inconvénient de cette technique d'épitaxie en phase vapeur réside dans la difficulté de faire croître latéralement des couches minces de silicium monocristallin sur isolant. Cette difficulté est liée à l'impossibilité d'obtenir des vitesses de croissance latérale (parallèlement au plan de l'isolant) sensiblement supérieures à la vitesse de croissance verticale perpendiculaire au même plan.

Les travaux les plus avancés ont été effectués à la Société RCA par L.JASTRZEBSKI et ses Collaborateurs. Les meilleurs résultats ainsi obtenus consistaient en des couches continues de silicium monocristallin avec des bandes de germination d'une largeur de 6 micromètres répétées tous les 12 micromètres. L'épaisseur initiale de la couche de silicium monocristallin sur SiO₂ était de 6 micromètres et cette dernière a été réduite à 0,6 micromètre par oxydation et attaques répétées. Une telle technique a été décrite dans le document "Preparation of Thin (0,6 micromètre) Continuous Monocrystalline Silicon over SiO₂" de L.JASTRZEBSKI et Coll, publié dans le Journal of the Electro-Chemical Society, 132(12), 1985, page 3056. Par ailleurs, amincir des couches plus épaisses à l'échelle d'une plaquette de 4 pouces ne serait pas réaliste. Les difficultés et les inconvénients de la méthode d'épitaxie latérale (ELO) démontrent qu'elle n'est pas applicable pour l'obtention de bandes de silicium sur isolant compatibles avec la réalisation de composants actifs pour circuits intégrés dont la largeur nécessaire doit être au minimum de 40 micromètres.

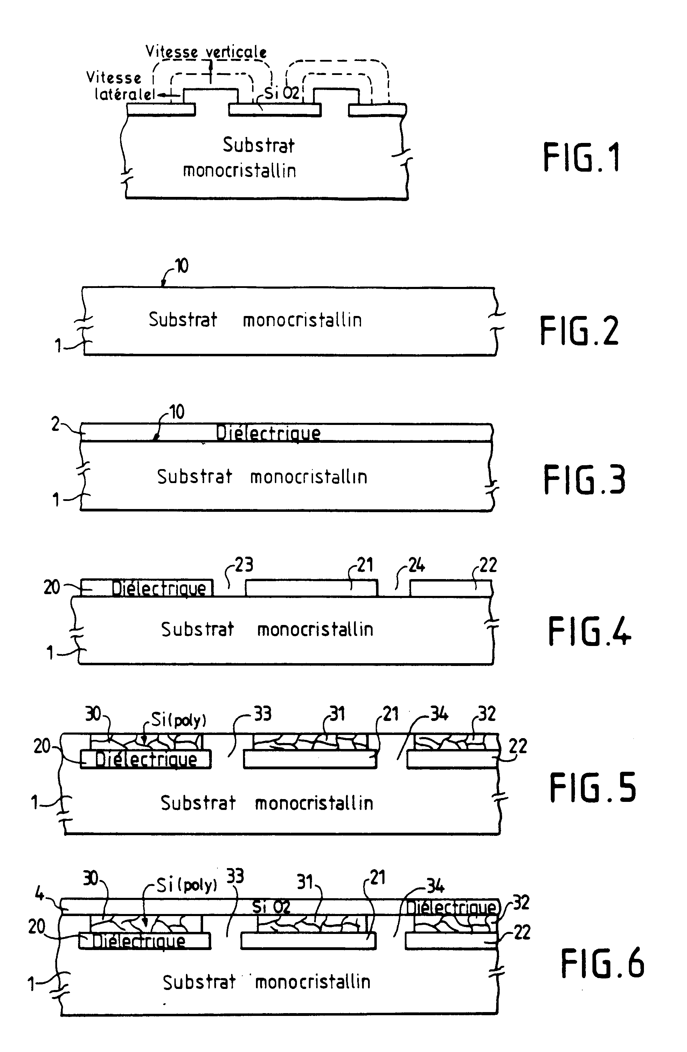

C'est ainsi, comme cela est représenté en figure 1, qu'une croissance de silicium monocristallin sur un substrat de silicium monocristallin muni sur sa face principale de zones d'isolants (silice SiO₂) s'effectue de façon telle que la croissance verticale, perpendiculaire à la face principale du substrat, présente une vitesse (vitesse verticale) sensiblement égale à la vitesse latérale correspondant à la croissance latérale parallèle à la face principale du substrat. On obtient une croissance telle que représentée en pointillés sur la figure 1. Il est alors impossible d'obtenir une couche mince (de l'ordre du micron) uniforme de silicium monocristallin recouvrant la couche de silice sur une grande surface.

L'invention concerne un procédé qui permet d'obtenir des couches minces de semiconducteur monocristallin en bandes de largeur supérieure à 100 micromètres.

L'invention concerne un procédé de réalisation d'une couche en matériau semiconducteur monocristallin, caractérisé en ce qu'il comporte :
- la réalisation d'une cavité délimitée par deux couches de confinement en matériau distinct de celui de la couche mince monocristalline à obtenir de telle façon que, lors d'une croissance, il ne pourra y avoir ni nucléation, ni dépôt du matériau semiconducteur sur les surfaces exposées des couches de confinement, ladite cavité comportant, à une extrémité, un élément ou germe en matériau semiconducteur monocristallin du même type que celui de la couche mince à obtenir et, à une autre extrémité, une ouverture;
- croissance en phase vapeur du matériau semiconducteur entre les deux couches de confinement, par l'ouverture à partir du germe de façon à obtenir une couche en matériau semiconducteur monocristallin.

L'invention concerne également un procédé de réalisation d'au moins une couche de matériau semiconducteur monocristallin sur une première couche d'un matériau isolant réalisée sur un substrat semiconducteur monocristallin, caractérisé en ce qu'il comporte les étapes suivantes :
a) une première étape de réalisation sur le substrat semiconducteur monocristallin de ladite première couche de matériau isolant présentant une sélectivité d'attaque chimique par rapport aux couches adjacentes et ne permettant ni nucléation, ni dépôt à partir des espèces de ladite phase vapeur sur sa surface exposée à la phase vapeur ;
b) une deuxième étape de gravure de premières ouvertures dans la première couche de matériau isolant ;
c) une troisième étape de réalisation dans les premières ouvertures, et sur les parties de la couche d'isolant restant après l'étape de gravure précédente, d'une couche d'un matériau semiconducteur, cette couche étant monocristalline dans les ouvertures et polycristalline sur l'isolant ;
d) une quatrième étape de réalisation d'une deuxième couche d'un matériau isolant sur la couche de matériau semiconducteur ;
e) une cinquième étape de gravure dans la deuxième couche de matériau isolant d'au moins une deuxième ouverture aboutissant sur une partie polycristalline de la couche de matériau semiconducteur ;
f) une sixième étape d'attaque chimique du matériau semiconducteur polycristallin de façon à supprimer tout le matériau semiconducteur polycristallin et éventuellement de façon a légèrement attaquer le matériau monocristallin ;
g) une septième étape de croissance sélective à partir d'une phase vapeur d'un matériau semiconducteur monocristallin dans le ou les espaces laissés libres par la disparition du matériau polycristallin.

Les différents objets et caractéristiques de l'invention apparaîtront plus clairement dans la description qui va suivre faite à titre d'exemple en se reportant aux figures annexées qui représentent :
- la figure 1, un exemple de réalisation de structure selon l'art connu ;
- les figures 2 à 13, différentes étapes d'un exemple de procédé de réalisation selon l'invention ;
- la figure 14, un exemple de réalisation de couches alternées de silicium monocristallin et d'isolant sur un substrat monocristallin ;
- les figures 15 à 19 les étapes d'une amélioration du procédé de réalisation selon l'invention ;
- la figure 20, la croissance latérale et la croissance verticale d'un matériau monocristallin selon le procédé de l'invention ;
- la figure 21, une croissance sur un substrat monocristallin type semiconducteur composé III-V ;
- les figures 22 à 31, une application du procédé selon l'invention à une réalisation sur un substrat semiconducteur de type III-V ;
- la figure 32, une étape d'isolation de couches monocristallines obtenues selon l'invention ;
- les figures 33 à 41, différentes étapes d'une variante du procédé selon l'invention ;
- les figures 42 à 45, une autre variante du procédé selon l'invention ;
- les figures 46 à 48, une variante du procédé selon l'invention dérivée de la variante représentée par les figures 42 à 45 ;
- les figures 49 à 51, une autre variante du procédé selon l'invention.

En se reportant aux figures 2 à 13 on va tout d'abord décrire un exemple de procédé de réalisation selon l'invention.

On dispose d'une plaque de substrat 1 en silicium monocristallin d'orientation cristallographique (100) par exemple telle que représentée en figure 2. Dans le cadre des techniques de circuits semiconducteurs, la plaque de substrat 1 peut être de dimensions relativement grande. Par exemple elle peut avoir un diamètre standard de 10 cm (4 pouces) ou plus.

La figure 3 représente la première étape du procédé selon l'invention au cours de laquelle on réalise une couche d'isolant 2 sur la face 10 de la plaque de substrat 1. Dans le cas d'un substrat silicium, la couche d'isolant est de la silice SiO₂ qui est obtenue soit par dépôt, soit par oxydation de la surface de la plaque de substrat 1. A titre d'exemple l'épaisseur de la couche d'isolant 2 est comprise entre 0,1 et 3 micromètres typiquement.

Au cours d'une deuxième étape représentée en figure 4, on définit par gravure de la couche d'isolant 2 des éléments 20, 21, 22 d'isolant.

Ces éléments sont des rubans d'isolant 20, 21, 22 séparés par des bandes 23, 24 ou le substrat monocristallin est mis à nu. Ces bandes peuvent avoir une largeur de 20 à 100 micromètres par exemple séparées par des espaces de 1 à 20 micromètres. La gravure de la couche d'isolant 2 peut se faire par tout procédé approprié tel que la photolithographie et attaque humide ou sèche. La gravure est telle que dans les espaces 23, 24, le matériau isolant 2 est complètement enlevé et que les espaces 23, 24 ne comportent que le silicium monocristallin du substrat exempt d'impuretés superficielles.

Au cours d'une troisième étape représentée en figure 5 on dépose une couche de silicium sur la structure précédente.

Ce dépôt peut se faire en phase vapeur ou Chemical Vapor Deposition (CVD). Le silicium 33, 34 sera alors monocristallin d'orientation (100) sur le substrat monocristallin également d'orientation (100) situé dans les espaces 23, 24. Par contre, il sera polycrystallin 30, 31, 32 sur les bandes d'isolant 20, 21, 22.

Ce dépôt peut se faire à pression atmosphérique (APCVD = Atmospheric Pressure Chemical Vapor Deposition) avec un mélange de silane (SiH₄) et d'hydrogène (H₂) à une température d'environ 950°C.

Ce dépôt peut également se faire à pression réduite (RPCVD : Reduced Pressure Chemical Vapor Deposition) avec un mélange de dichlorosilane et d'hydrogène SiH₂Cl₂+H₂ à une température d'environ 850°C. Cette dernière façon de procéder est thermiquement plus avantageuse.

D'autre part, la vitesse de croissance dans une direction perpendiculaire au plan du substrat étant plus importante sur les bandes de monocristal que sur la silice, on arrive après un certain temps de dépôt (qui dépendra de l'épaisseur des bandes de silice) à un dépôt d'épaisseur uniforme sur la totalité de la plaquette. (On appellera cette opération la "planarisation" du dépôt).

Afin d'obtenir une meilleure planarisation, on peut tout d'abord remplir les espaces 23, 24 de silicium monocristallin (100) en contact avec le substrat, sans réaliser de dépôt sur les bandes d'isolant 20, 21, 22, (conditions de dépôt et d'épitaxie sélectifs), puis faire un dépôt uniforme de silicium sur les bandes d'isolant 20, 21, 22 et les espaces 23, 24 préalablement remplis de silicium monocristallin. Le remplissage sélectif des espaces 23, 24 de silicium monocristallin (100) se fait soit par CVD à pression atmosphérique (APCVD) à une température comprise entre 1000 et 1060°C en utilisant un mélange gazeux SiH₄/HCl/H₂, soit encore par CVD à pression réduite (RPCVD) à une température comprise entre 850 et 900°C en utilisant un mélange gazeux SiH₂Cl₂/HCl/H₂ . (Voir les articles de BORLAND, de CHAPUIS et de KARAPIPERIS déjà cités).

Cette méthode de dépôt sélectif s'appui sur un mécanisme de nucléation sélective, par lequel la croissance du silicium est possible sur des surfaces à faible barrière de nucléation (silicium (100) par exemple) tandis qu'aucune nucléation n'a lieu sur des surfaces étrangères comme la silice par exemple. Pour obtenir cette sélectivité, il faut travailler en conditions de sursaturation très légère et en utilisant des mélanges gazeux appropriés.

Au cours d'une quatrième étape représentée en figure 6, on réalise sur la structure ainsi obtenue une couche d'isolant 4 telle que de la silice (SiO₂) si le matériau utilisé dans ce qui précède est du silicium. Cette couche de silice peut être formée soit par oxydation thermique, soit par dépôt, soit par une approche mixte de type thermique et de dépôt combinés. Pour le dépôt on préférera utiliser une méthode haute température (HTO) ; par exemple une pyrolyse de SiH₂Cl₂ et N₂0 à 850°-900°C de façon à obtenir une silice de bonne qualité. L'épaisseur de cette couche de silice sera par exemple comprise entre 0,5 et 3 micromètres.

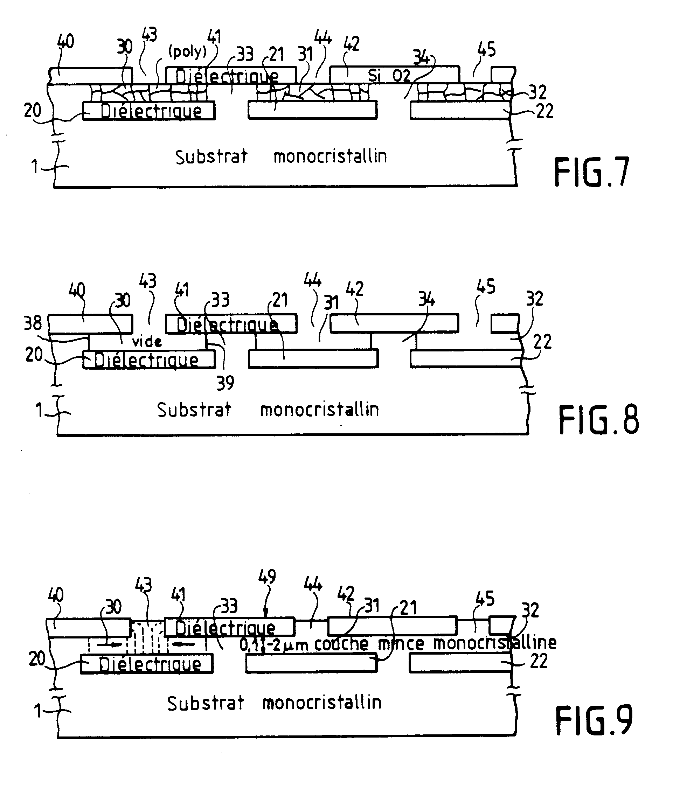

Au cours d'une cinquième étape représentée en figure 7, on réalise, dans la couche d'isolant 4, des ouvertures 43, 44, 45 situées aux dessus des zones de matériau polycristallin 30, 31, 32. En application de l'exemple de réalisation précédent où les éléments isolant 20, 21, 22 sont sous forme de bandes, les ouvertures 43, 44, 45 sont également faites sous forme de bandes de largeur nettement inférieure à la largeur des bandes d'isolant 20, 21, 22. C'est ainsi que, par exemple, les bandes d'isolant 20, 21, 22 ayant une largeur de 20 à 100 micromètres, la largeur d'ouvertures 43, 44, 45 pourra être comprise entre 1 et 20 micromètres. Dans ces ouvertures 43, 44, 45 l'isolant est complètement enlevé et laisse apparaître des bandes de silicium polycristallin situées sensiblement et préférentiellement au centre des zones en matériau polycristallin 30, 31, 32.

Au cours d'une sixième étape représentée en figure 8, le silicium polycristallin 30, 31, 32 est enlevé par attaque chimique en utilisant les ouvertures 43, 44, 45 pratiquées dans la couche 4 d'isolant. L'attaque est arrêtée lorsque le silicium monocristallin des parties 33 et 34 est mis à nu.

Cette sixième étape d'attaque peut être complétée par une phase de décapage de façon a enlever toute impureté ou imperfection qui pourrait subsister.

Au cours d'une septième étape représentée en figure 9, on fait croître latéralement en conditions d'épitaxie sélective (conditions décrites précédemment), à partir des germes de silicium monocristallin précédemment mis à nu (38 et 39), un ruban de silicium monocristallin. Les conditions opératoires pour cette croissance sont similaires à celle de la deuxième partie de la troisième étape telle que décrite précédemment. La croissance monocristalline ne peut s'effectuer que latéralement et non verticalement, car elle est canalisée dans chaque cavité (30, 31, 32) par le chapeau d'isolant (couches de silice 40, 41, 42) et les bandes de silice sous-jacentes (20, 21, 22). Lorsque le ruban de silicium commence à déborder des chapeaux de silice dans les ouvertures 43, 44, 45, la croissance s'effectue aussi perpendiculairement au plan du substrat comme indiqué par les traits pointillés de la figure 9. On remplit ainsi les différents intervalles laissés vides après l'attaque du silicium polycristallin.

Pour certaines applications, on peut envisager de ne remplir l'espace sous le "chapeau d'isolant" que jusqu'au bord, sans déborder et sans faire joindre les deux fronts de Silicium monocristallin avançant en direction opposées.

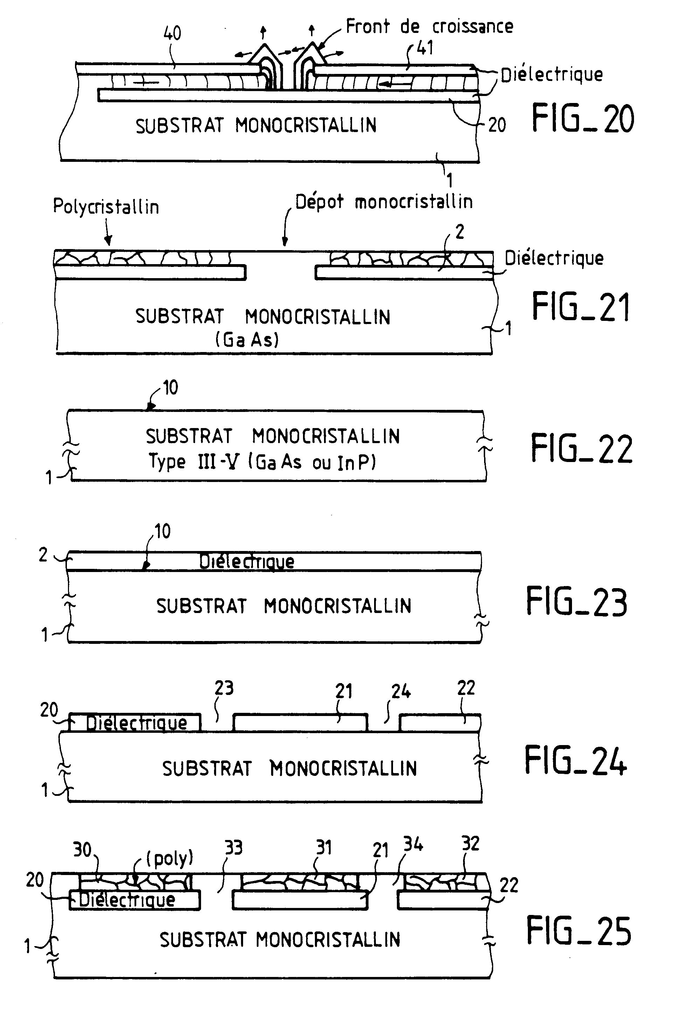

Si les ouvertures 43, 44 45 entre les bandes de silice supérieures 40, 41, 42 sont de largeur trop importante, la jonction entre les deux fronts de cristallisation ne s'opérera qu'au prix d'une croissance verticale aussi trop importante (voir figure 20). Il deviendra alors difficile de "planariser" la structure par des méthodes simples. Pour pallier cet inconvénient, on peut introduire un certain nombre d'étapes supplémentaires qui seront décrites ultérieurement dans une variante du procédé de réalisation de l'invention.

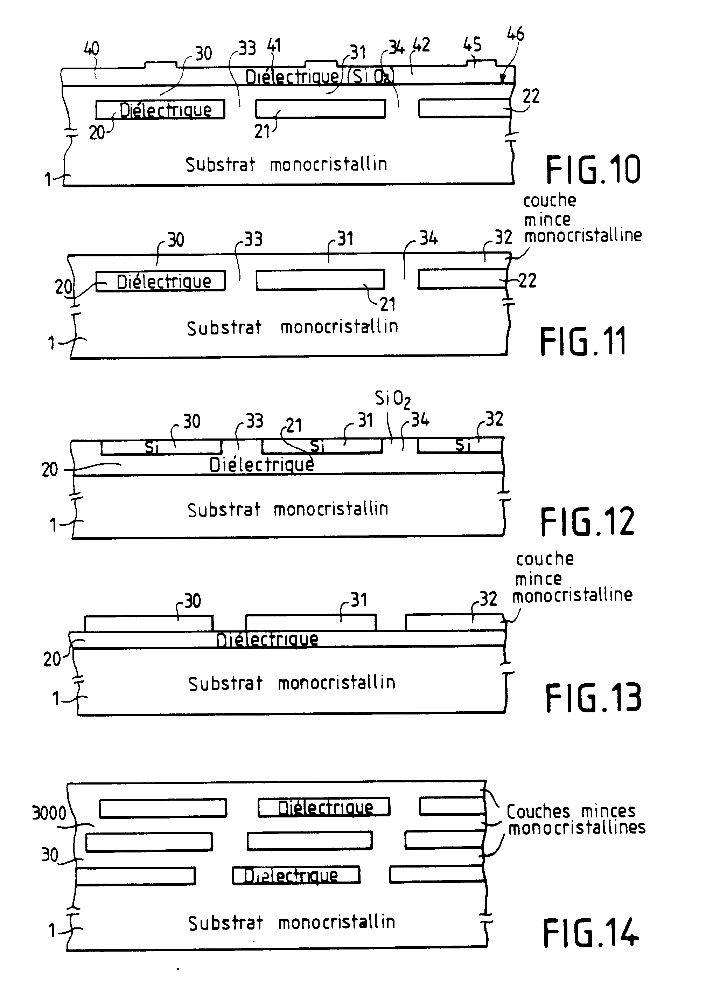

Au cours d'une huitième étape représentée en figure 10, on oxyde le dépôt de silicium monocristallin qui vient d'être déposé. Cette oxydation n'affecte pratiquement que le silicium monocristallin situé dans les ouvertures 43, 44, 45. Cette oxydation est faite en profondeur de façon à ce que les faces inférieures de silicium oxydé dans les bandes 43, 44 et 45 affleurent les faces inférieures des couches 40, 41, 42. On obtient ainsi, comme représenté en figure 10, une face 46 sensiblement continue et plane.

De plus, selon la hauteur de silicium monocristallin obtenu, lors de la septième étape, dans les ouvertures 43, 44, 45, la face supérieure de silicium oxydée n'est pas obligatoirement plane et peut, par exemple, comme représenté en figure 10, présenter des protubérances de silicium oxydé à l'endroit des ouvertures 43, 44, 45. Cependant ces irrégularités de surface n'ont pas d'influence sur la qualité du composant qui sera obtenu dans la suite du procédé, puisque la couche de silicium oxydé sera éliminée.

Au cours d'une neuvième étape représentée en figure 11, on enlève la silice sur toute la surface de la plaquette de façon à obtenir une couche uniforme de silicium monocristallin (30, 31, 32). L'épaisseur de cette couche de silicium monocristallin peut être typiquement de 0,1 à 2 micromètres sur les bandes de silice 20, 21, 22 (de largeur 20 à 100 micromètres). On peut ainsi réaliser, sur chaque bande de silice, des composants en silicium sur isolant (SOI).

L'isolation de bandes silicium SOI peut être effectuée de deux façons au cours d'une dixième étape.

Au cours d'une dixième étape, on isole donc les unes des autres les bandes de silicium monocristallin 30, 31, 32 correspondant chacune à une bande d'isolant 20, 21, 22.

Selon l'exemple de la figure 12 on procède à une oxydation localisée du silicium situé au dessus des ouvertures précédentes 33, 34 ainsi que du silicium situé dans ces ouvertures.

On obtient ainsi des bandes 30, 31, 32 de silicium monocristallin isolées entre elles ainsi que du substrat 1 par de la silice.

Selon l'exemple de la figure 13 pour réaliser des bandes de silicium monocristallin, on complète l'oxydation localisée réalisée en figure 12 par une gravure chimique ou sèche des bandes de silice réalisées. On obtient ainsi, comme cela est réalisé en figure 13, des bandes de silicium monocristallin 30, 31, 32 distinctes les unes des autres et isolées du substrat 1 par une couche de silice ; ou bien, dans une variante, à partir de l'état de la figure 11, on grave le silicium sur les bandes 33, 34 et ce, jusqu'à la moitié de l'épaisseur des bandes d'isolant en silice et l'on pratique ensuite une oxydation localisée du silicium dans ces bandes de façon à obtenir une bande de silice continue.

Selon l'exemple de réalisation de la figure 14, on peut, en répétant le procédé décrit précédemment, réaliser sur la structure de la figure 11, une deuxième, puis une troisième structure similaire, et ainsi de suite. On peut ainsi obtenir une alternance de couches de silicium monocristallin et d'isolant (silice). Un réseau de bandes de silicium sur isolant peut donc être réalisé, les zones de germination pouvant être superposées ou décalées.

En réalisant sur le substrat initial et successivement sur chaque niveau de silicium des composants actifs, on obtient un circuit intégré à trois dimensions, l'élaboration de la couche j de Si se faisant sans dégradation de la couche j-1 déjà réalisée et comprenant des composants actifs, du fait de la relativement basse température utilisée dans le procédé CVD.

La succession des étapes précédentes a été décrite en s'appuyant sur un diélectrique qui était de la silice. Ce diélectrique peut être remplacé par tout autre matériau isolant polycristallin ou amorphe (Si₃N₄ ; Al₂O₃...) étant entendu que l'on peut obtenir les conditions de dépôt et d'épitaxie sélectifs précédemment décrites ou par une combinaison de plusieurs de ces matériaux (par exemple silice pour la couche 2 et nitrure de silicium pour la couche 4).

Selon une variante du procédé de l'invention, si les ouvertures 43, 44 et 45 obtenues à l'issue de la cinquième étape dans la couche 4 d'isolant (figure 7) sont trop larges, la croissance du silicium, lorsque le ruban monocristallin va échapper à la contrainte du chapeau d'isolant, va s'effectuer aussi verticalement et la jonction entre les deux fronts de cristallisation ne va s'opérer qu'au prix d'une croissance verticale dans les ouvertures 43, 44, 45 trop importance qui rendra la "planarisation" ultérieure du dépôt délicate (voir figure 20). En effet, pour que le flux de gaz permettant l'épitaxie par CVD pénètre aisément dans une cavité telle que 30 de la figure 8, il faut que l'ouverture 43 soit en rapport avec les dimensions de cette cavité. De plus, l'épaisseur de la couche 4 d'isolant est relativement faible (O,2 à 5 micromètres). Le porte à faux des extrémité des bandes d'isolant 40, 41, 42 ne doit pas être trop important, sinon on risque une déformation de ces bandes sous leur propre poids et on n'obtiendra pas alors des couches de silicium monocristallin d'épaisseur uniforme. Ceci limite donc l'extension potentielle latérale du cristal. Pour pallier ces différents inconvénients, on peut être amené a pratiquer au cours de la cinquième étape des ouvertures 43, 44, 45 relativement larges.

Cependant, comme nous l'avons vu, la largeur des ouvertures 43, 44, 45 conduit à avoir des fronts de croissance verticale qui provoquent des inégalités de surface dans les ouvertures 43, 44, 45 après dépôt (voir figure 20). Pour éviter ces inégalités et ce sans limiter pour autant l'extension latérale du cristal, l'invention propose des variantes de réalisation.

Selon une première variante, on prévoit lors de la septième étape précédemment décrite de laisser déborder la croissance du silicium après dépassement des bandes de silice 40, 41, 42 et d'effectuer, après jonction des fronts de cristallisation (obtenue au prix d'une croissance verticale locale non négligeable comme le montre la figure 20) , un polissage mécanochimique qui s'arrêtera lorsque le plan supérieur de la silice aura été atteint, par sélectivité du réactif utilisé lors de l'opération de polissage (silice coloïdale en particulier).

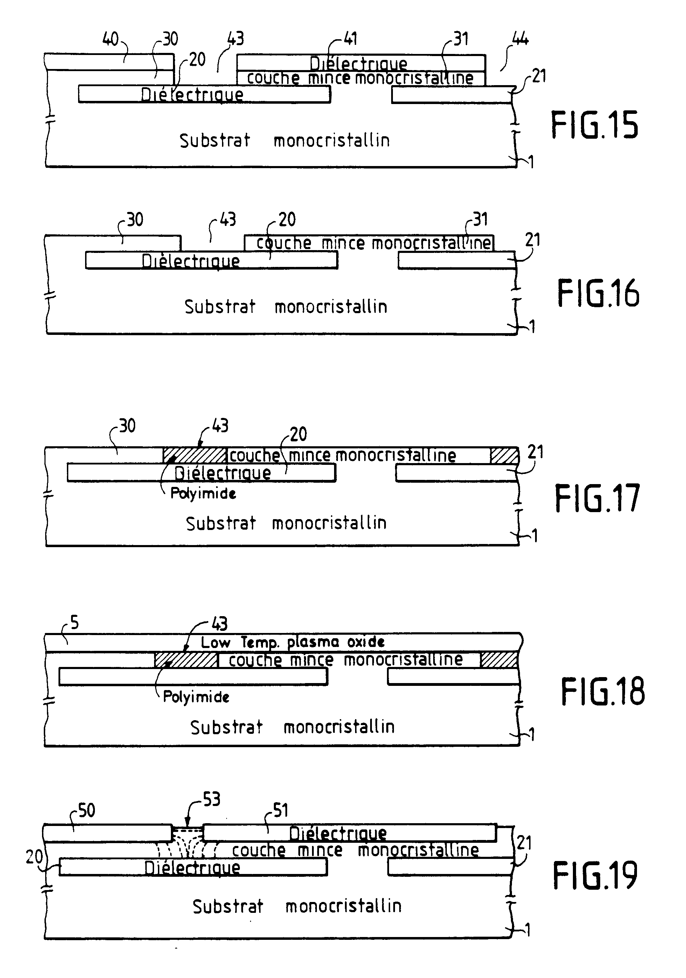

Selon une deuxième variante, on prévoit, au cours de la septième étape précédemment décrite, d'arrêter le dépôt de silicium lorsque la croissance atteint les flancs des ouvertures 43, 44. On obtient ainsi une structure telle que représentée en figure 15.

Au cours d'une première phase auxilaire représentée en figure 16, on enlève alors les couches supérieures 40, 41 de silice en masquant préalablement les couches inférieures 20, 21.

Au cours d'une deuxième phase auxiliaire représentée en figure 17 et après enlèvement du produit de masquage de la silice 20, 21 on "planarise" la structure à l'aide d'un dépôt type polyimide effectué à la tournette par exemple (machine à déposer les résines photosensibles), employant une étape d"etch back", si nécessaire.

Au cours d'une troisième phase auxiliaire représentée en figure 18, on dépose une couche d'oxyde (SiO₂) 5 ou de nitrure (Si₃H₄) à basse température (LTO) par pyrolyse de SiH₄+N₂O assistée par plasma à 250°C (par exemple) sur la structure précédemment planarisée.

Au cours d'une quatrième phase auxiliaire on découpe dans cette dernière couche de silice ou de nitrure 5 des ouvertures 53 de façon à se ramener à une structure identique à celle obtenue lors de la description de la cinquième étape précédente. L'ouverture dans la silice est à présent compatible avec un remplissage correct (sans débordement vertical pour obtenir la jonction des deux fronts de cristallisation) des bandes vides comprises entre les bandes de silice. On dissout au cours d'une cinquième phase auxiliaire le polyimide à l'aide d'un solvant approprié et on répète l'opération de croissance latérale décrite dans la septième étape tel que cela est représenté en figure 19 ; on est ainsi ramené au cas de la figure 9 à partir duquel on peut répéter l'étape 8 et les suivantes précédemment décrites. Cette série d'étapes auxiliaires peut éventuellement être reproduite plusieurs fois si nécessaire.

Le procédé de l'invention permet ainsi, à titre général, de réaliser une couche mince d'un matériau semiconducteur monocristallin en effectuant une croissance, en phase vapeur de ce matériau semiconducteur, entre deux couches (20, 40, 41) d'un matériau (voir figure 8) différent du semiconducteur et sur lequel on n'observe ni nucléation ni dépôt du matériau semiconducteur en question durant la croissance. Les couches 20, 40, 41 définissent un volume vide 30 dont l'épaisseur détermine l'épaisseur de la couche de matériau semiconducteur à obtenir.

Les extrémités 38, 39 (figure 8) du volume 30 sont composées de matériau semiconducteur identique au matériau semiconducteur utilisé pour la croissance. Le matériau semiconducteur aux extrémités 38, 39 sert ainsi de germes pour la croissance latérale de la couche mince de matériau semiconducteur monocristallin.

Dans ce qui précède, l'application de l'invention à une structure à base de silicium n'a été fournie qu'à titre d'exemple. L'invention est également applicable à titre général à une structure à base de semiconducteurs de type quelconque, pourvu que la sélectivité de dépôt entre une surface étrangère (pas nécessairement diélectrique) et la surface du semiconducteur puisse être atteinte. Ainsi, l'invention peut être appliquée aux composés III-V de type GaAs, InP etc..., moyennant quelque aménagements technologiques particuliers. Le problème est d'obtenir des conditions de dépôt sélectif.

En ce qui concerne les composés III-V et le GaAs en particulier, on utilisera de préférence pour obtenir cette sélectivité de dépôt, une méthode permettant de se placer près de l'équilibre thermodynamique en conditions de légère sursaturation. Ainsi, la méthode d'épitaxie en phase vapeur à partir de chlorures (VPE), permet d'opérer dans de telles conditions ; on utilise d'une part AsCl₃ et éventuellement HCl dilués dans H₂ en tant que sources gazeuses et d'autre part Ga comme source solide. On opère dans un four où la température de la source de Ga est par exemple de l'ordre de 800°C, tandis que l'échantillon sur lequel on travaille est maintenu à une température inférieure, de l'ordre de 650 - 700°C, ce qui donne la condition de sursaturation légère annoncée.

En ce qui concerne InP on travaille avec une source gazeuse PH₃ et HCl dans H₂ et une source solide In. L'échantillon est placé autour de 700°C et la source d'In est chauffée à température supérieure de même que précédemment.

En utilisant les paramètres précités, on obtient une nucléation sélective sur les parties cristallines exposées du substrat (surfaces à faibles barrières de nucléation) ; par suite, on observe un dépôt sur ces mêmes parties exposées et aucun dépôt sur des surfaces étrangères à barrière de nucléation plus élevée (surfaces diélectriques par exemple, mais aussi surfaces métalliques tel que tungstène).

Des exemples de cette sélectivité de depôt entre GaAs et SiO₂ et InP et SiO₂ peuvent être trouvés à titre indicatif dans un article récent de M. ERMAN et Collaborateurs, SPIE.Vol. 651, Integrated Optical Circuit Engineering III (1986) p.75.

Selon les conditions d'orientation des bandes ouvertes dans la silice déposée et selon la fraction molaire de AsCl₃ dans le mélange gazeux on obtient des facettages différents pour le dépôt monocristallin (voir par exemple l'article de N.VODJANI et Collaborateurs, dans Journal of Crystal Growth 71, 1985,p.141).

On a cité GaAs et InP à titre d'exemple, mais on peut aussi déposer, de façon sélective, des alliages ternaires ou quaternaires (GalnAsP) en utilisant des sources gazeuses As H₃, PH₃ et HCl dans H₂ et des sources solides Ga et In et toujours en se plaçant près de l'équilibre thermodynamique en conditions de légère sursaturation.

Si (toujours concernant les composés III-V) l'on utilise une méthode de depôt fonctionnant à pression atmosphérique et très loin de l'équilibre thermodynamique, telle que la MOCVD par exemple (de l'anglais Metal Organic Chemical Vapour Deposition) on dépose du matériau semiconducteur monocristallin sur les surfaces de germination exposées du substrat monocristallin et du matériau polycristallin sur les surfaces étrangères (diélectrique ou métalliques) comme le représente la figure 21 (voir par exemple l'article de R.AZOULAY et Collaborateurs dans Journal of Crystal Growth 55, 1981,p.229).

Dans cette méthode MOCVD, la source de composé III est organométallique (triméthylgallium, triéthylgallium, triméthylindium, triéthylindium, etc...) tandis que la source du composé V est un hydrure (AsH₃, PH₃..). Précisions tout de même que dans certaines conditions et toujours en travaillant à pression atmosphérique, on peut obtenir une certaine sélectivité de dépôt en travaillant avec des bandes de silice ou de tungstène de largeur inférieure à 40 µm, ce qui est toutefois très limitatif et difficilement exploitable (voir K.YAMAGUCHI et Collaborateurs, Japanese Journal of Applied Physics, vol.24, n° 12,1985,p.1666).

Par contre, en travaillant à pression réduite (13.3 hPa (10mm de colonne de Hg)) et toujours en utilisant la méthode MOCVD, K.KAMON et Collaborateurs (Journal of Crystal Growth 73, 1985, p.73) ont démontré, récemment, que l'on pouvait aussi obtenir une excellente sélectivité de dépôt entre une surface (001) de GaAs exposée et un film de nitrure de silicium (SiNₓ) déposé par CVD plasma à 250°C. Bien que la méthode utilisée (MOCVD) se situe hors de l'équilibre thermodynamique, la sélectivité est obtenue du fait d'une plus grande diffusivité superficielle, sur les surfaces diélectriques, des produits de décomposition du triméthylgallium (ou du triméthylindium) dans les conditions de pression réduite utilisées.

Finalement, il convient de noter qu'en utilisant la technique de l'épitaxie par jet moléculaire (ou MBE de l'anglais Molecular Beam Epitaxy) à partir de composés organo métalliques du gallium ou de l'indium (triméthylgallium ou triéthylindium, etc...) on obtient aussi la même sélectivité de dépôt, bien qu'étant très loin de l'équilibre thermodynamique, ceci probablement pour les même raisons de diffusivité superficielle accrue sur les surfaces diélectriques lorsque la pression environnante est faible (voir par exemple l'article de E. TOKUMITSU et Collaborateurs dans Journal of Applied Physics, 55, 1984, 3163).

En résumé, on sait maîtriser l'épitaxie sélective de composés III-V divers (GaAs, InP, GaInAs, GaInAsP, etc...) par plusieurs techniques distinctes, à savoir :
- (i) épitaxie en phase vapeur par la méthode des chlorures (VPE),
- (ii) épitaxie en phase vapeur et à basse pression par la méthode des organo métalliques (LP.MOCVD) et ,
- (iii) épitaxie par jet moléculaire par la méthode des organo métalliques (MOMBE).

De plus, la méthode MOCVD à pression atmosphérique permet de déposer des couches continues polycristallines sur les surfaces diélectriques et monocristallines sur les surfaces exposées d'un substrat aussi monocristallin.

Si l'on garde ce résumé en mémoire, on voit que l'on peut tout d'abord effectuer en homoépitaxie (ou en hétéroépitaxie d'un composé présentant le même paramètre de maille) des empilements de couches III-V monocristallines isolées par des couches diélectriques. Une façon de réaliser cet empilement est décrit dans ce qui suit.

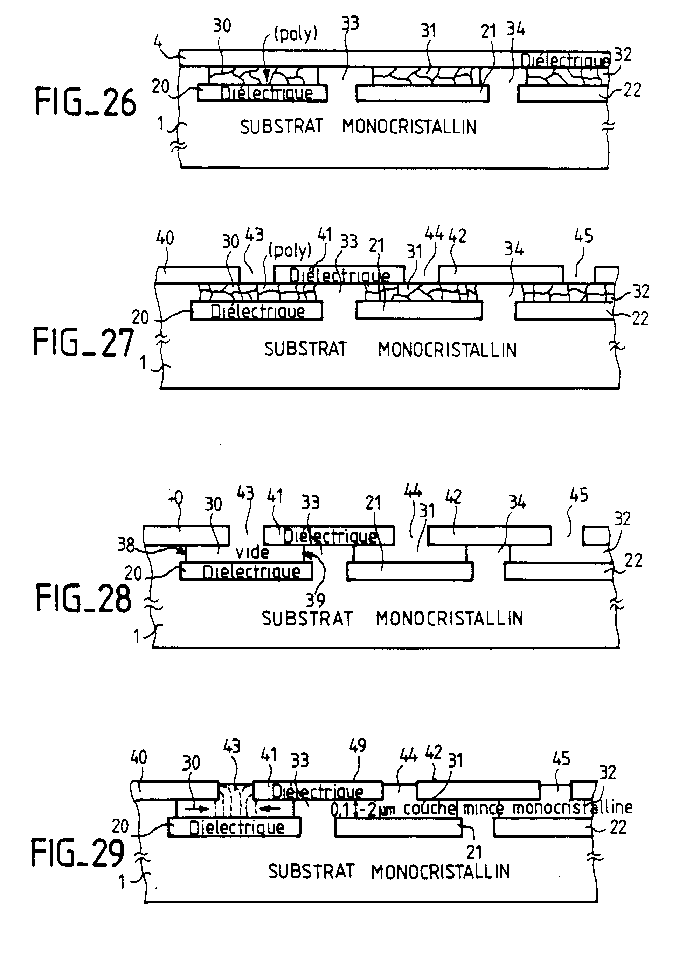

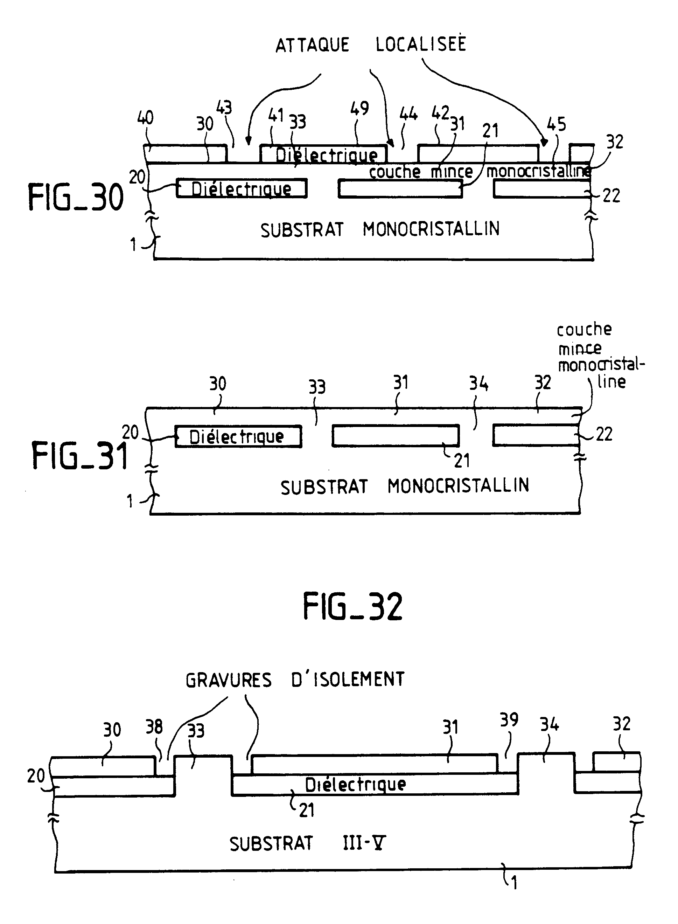

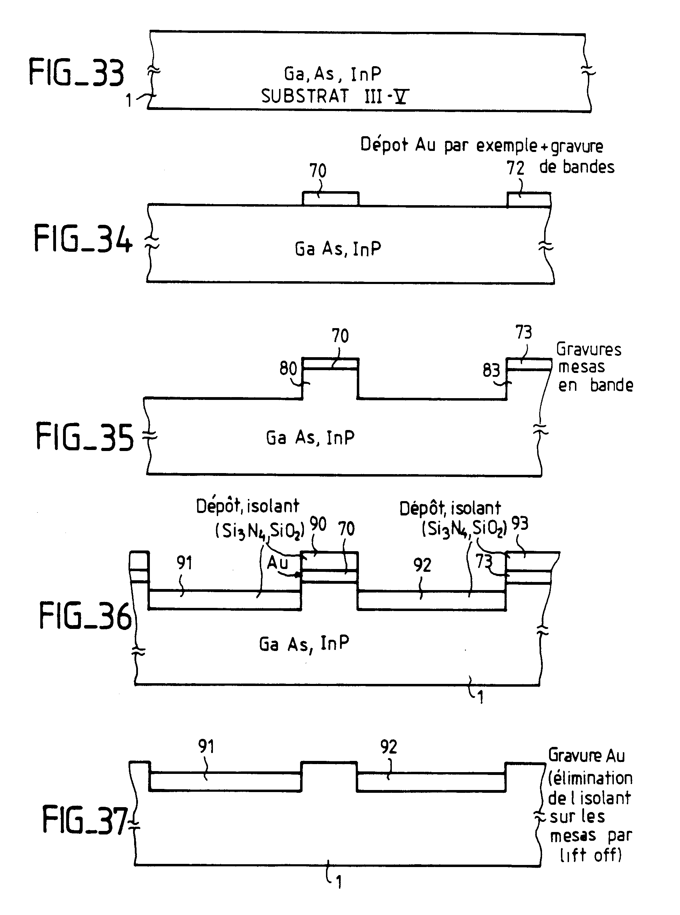

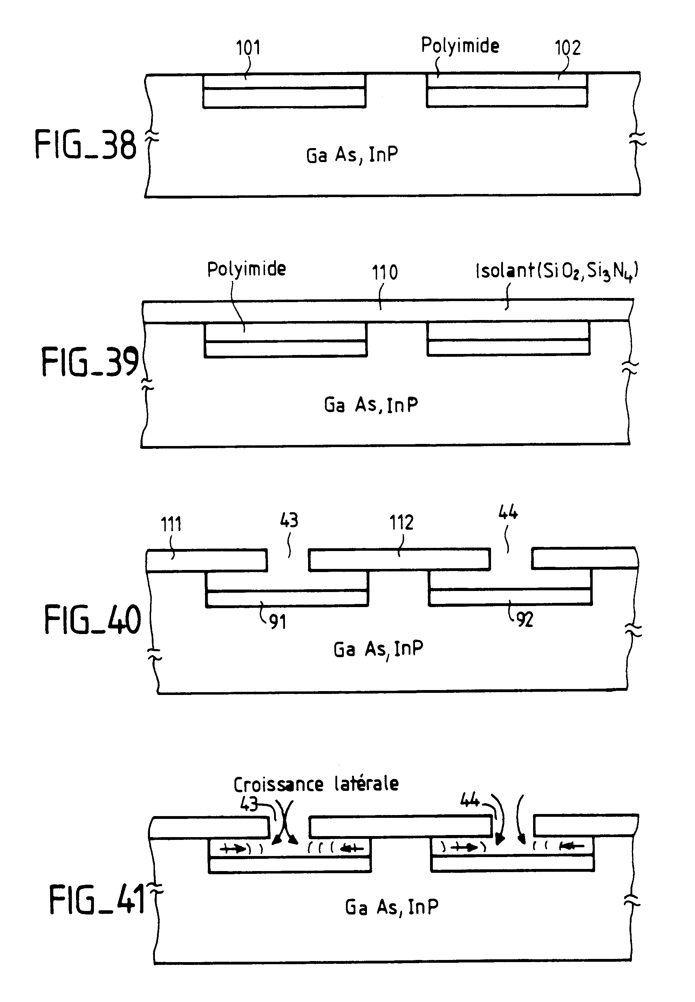

Pour mettre en oeuvre le procédé de l'invention en ce qui concerne des composés semiconducteurs III-V, on effectuera les différentes étapes décrites dans ce qui suit :
Etape 1: On part d'une plaquette standard 1 en GaAs ou InP de diamètre 5 ou 7,5 cm (2 ou 3 pouces), d'orientation (100) ou (110). (Figure 22).
Etape 2: On dépose, par les moyens connus de l'homme de l'art. (Pulvérisation cathodique, évaporation sous vide, CVD, CVD plasma, etc...) une couche mince 2 d'un matériau diélectrique qui peut par exemple être du nitrure de silicium Si₃N₄, de la silice SiO₂, des oxydes tels que Al₂O₃..., ou des fluorures tels que CaF₂, etc... L'épaisseur de ce dépôt est comprise entre typiquement 5·10⁻² et quelques micromètres. On grave ensuite dans ce diélectrique par les moyens connus de l'homme de l'art un ensemble de bandes 23, 24 de largeur 0,5 à quelques micromètres et espacées de quelques micromètres à quelques centaines de micromètres qui mettent ainsi périodiquement à nu le substrat monocristallin. (Figures 23 et 24).
   L'orientation des bandes de substrat 23 mises à nu sera effectuée de telle façon que, compte tenu des conditions de dépôt sélectif ultérieurement utilisées (par exemple fraction molaire de AsCl₃ en VPE), la facette de croissance latérale ne soit pas limitante. Ainsi, si l'on utilise un substrat de GaAs d'orientation (110), les bandes seront orientées entre 0 et 40° de la direction (110) ceci correspondant à des vitesses de croissance latérale importantes (voir par exemple l'article de C.O. BOZLER et Coll. dans Journal of Vacuum Science and Technology 20, Mars 1982, p 720).
Etape 3: On dépose, par exemple par MOCVD à pression atmosphérique ou bien en MBE classique, une couche mince de composé III-V de maille accordée au substrat sur la structure précédente. Cette couche sera monocristalline sur les endroits exposés du substrat et polycristalline sur le diélectrique. L'épaisseur de cette couche sera de quelques 10⁻² à quelques micromètres. La planarisation est obtenue soit naturellement (la vitesse de croissance est plus rapide sur les parties monocristallines que sur le diélectrique) soit, si l'épaisseur de diélectrique est grande, en effectuant préalablement un dépôt sélectif en travaillant par exemple en MOCVD sous pression réduite, ce qui a pour effet de remplir les ouvertures pratiquées dans le diélectrique avec du matériau monocristallin sans que l'on observe de dépôt sur ce même diélectrique. (Figure 25).
Etape 4: On redépose sur la structure planarisée précédente une deuxième couche de diélectrique d'épaisseur quelques 10⁻² à quelques micromètres. (Figure 26).
Etape 5: On grave de même que précédemment des ouvertures dans cette deuxième couche de diélectrique ; ces ouvertures sont décalées par rapport aux précédentes, ce décalage pouvant varier entre quelques micromètres et quelques centaines de micromètres. (Figure 27). Ces ouvertures sont situées dans la partie centrale du matériau polycristallin.
Etape 6 : A partir de ces ouvertures, on enlève le matériau III-V polycristallin par attaque chimique, de façon à mettre à nu le germe monocristallin. (Figure 28).
Etape 7: On fait croître à partir du germe précédemment mis à nu et en conditions d'épitaxie sélective (VPE, L.P MOCVD ou MOMBE) un ruban de matériau III-V qui va s'étendre latéralement de part et d'autre du germe. On obtient ainsi une couche mince de matériau III-V monocristallin comprise entre deux couches de diélectrique. (Figure 29).
   On peut ainsi remplir complètement les ouvertures dans le diélectrique supérieur (si toutefois leur largeur est compatible avec cette opération), de façon à ce que les deux fronts de cristallisation issus de deux germes adjacents se rejoignent.
Etape 8: On effectue la planarisation du dépôt précédent (au niveau des ouvertures 43, 44, 45), par exemple par attaque sélective dans un plasma à base de CF₄ ou CF₄ + He etc..., de façon à obtenir une surface supérieure du dépôt monocristallin sensiblement plane. (Figure 30).
Etape 9: On enlève le diélectrique supérieur, sur tout la surface de la plaquette, de façon à obtenir une couche mince monocristalline de semiconducteur, isolée du substrat par les bandes de diélectrique inférieur et communiquant avec ce même substrat par des puits monocristallins. (Figure 31).
Etape 10: On peut effectuer l'isolation complète de la couche mince 30, 31, 32 en gravant localement cette dernière dans des zones 38, 39, de façon à désolidariser la couche mince 30, 31, 32 des puits monocristallines 33, 34 communiquement avec le substrat comme cela est représenté en figure 32.
   On peut répéter à partir de l'étape 9 précédente l'ensemble des étapes 3 à 8 précédemment décrites de façon à obtenir un empilement tel que celui représenté à la figure 14.
   De même que précédemment, lorsque la largeur des bandes 43, 44 et 45 ouvertes dans le diélectrique supérieur est trop importante, la croissance va déborder du plan supérieur du diélectrique comme cela est représenté sur la figure 20. On introduit donc pour pallier cet inconvénient une variante qui est la même que celle représentée par les figures 15 à 19.
   D'autre part, on peut trouver des variantes à l'exemple de réalisation présenté sur les figures 22 à 32.
   Ainsi une première variante du procédé décrit selon les Etapes 1 à 7 est commenté dans ce qui suit en se reportant aux figures 33 à 41.
Etape 11: De même que précédemment on part d'un substrat de composé III-V, GaAs ou InP représenté en figure 33.
Etape 12: On dépose et on grave des bandes 70, 71 par exemple métalliques (Au, Pt, etc...) ou bien organiques (résine, polymère, PMMA, polyimide...). Ces bandes vont essentiellement servir de masque de gravure pour l'étape suivante. La largeur de ces bandes est de 0,5 à quelques micromètres et elles sont espacées de quelques micromètres à quelques centaines de micromètres. Une telle structure est représentée en figure 34.
Etape 13: On grave dans le substrat 1, en utilisant comme masque les bandes 70, 73 précédemment déposées, un réseau de mésas aussi en bandes. Les dimensions caractéristiques sont bien sur les mêmes que précédemment, c'est à dire de 0,5 à quelques micromètres pour la largeur des bandes de mésas et de quelques micromètres à quelques centaines de micromètres pour l'espacement entre bandes de mésas. La profondeur de gravure est typiquement de quelques 10⁻² à quelques micromètres. (Figure 35).
Etape 14: On dépose par les moyens connus de l'homme de l'art un diélectrique 90 à 93 (SiO₂), Si₃N₄...) sur la structure précédente. L'épaisseur de ce diélectrique sera aussi de quelques 10⁻² à quelques micromètres, mais dans tous les cas elle sera inférieure à la profondeur de la gravure effectuée lors de l'étape 13. (Figure 36).
Etape 15: Comme représenté en figure 37, on élimine par 'lift off" les couches de diélectriques 90, 93 sur les mésas (et uniquement sur les mésas), en attaquant les bandes métalliques ou de résine déposées lors de l'étape 12.
Etape 16: On planarise la structure précédente à l'aide d'un matériau type polyimique 101, 102 déposé à la tournette. (Figure 38).
Etape 17: On dépose à basse température, par les moyens connus de l'homme de l'art, une couche diélectrique 110 d'épaisseur 10⁻² à quelques micromètres. (Figure 39).
Etape 18: On grave des ouvertures 43, 44 (sous forme de bandes) dans le diélectrique précédent, celles-ci étant décalées par rapport aux mésas et disposées dans la partie centrale de l'évidement abritant le polyimide ; on élimine le polyimide par dissolution à l'aide d'un solvant approprié. Cette opération a pour effet de remettre à nu le germe monocristallin sur les flancs latéraux des mésas. On obtient ainsi une structure telle que représentée en figure 40.
Etape 19: De même que précédemment (Etape 7), on fait croitre en conditions de dépôt et d'épitaxie sélectifs (VPE, LP MOCVD, MOMBE) la couche mince (de composé III-V par exemple) à partir des germes formés par les flancs des mésas, comme cela est représenté en figure 41.

On pourra, ainsi que précédemment, lorsque les ouvertures (43, 44) dans la deuxième couche diélectrique sont trop larges, opérer selon la méthode décrite sur les figures 15 à 19 afin d'éviter le débordement dans le plan supérieur du diélectrique de la couche en cours de croissance. Dans tous les cas, on arrive à une situation comparable à celle représentée à la figure 29, ce qui permet d'effectuer ensuite les étapes représentées aux figures 30, 31, 32 et 14 de même que précédemment décrit.

Au cours de l'étape 3 (représentée sur la figure 5) du procédé précédemment décrit, on a prévu un dépôt de matériau semiconducteur qui est monocristallin sur les zones de germination 23 et 24 et polycristallin sur les zones diélectriques 20, 21, 22. Pour diverses raisons, il peut être souhaitable de découpler les deux parties de ce dépôt simultané. On propose dans ce qui suit deux façons différents d'effectuer ce découplage.

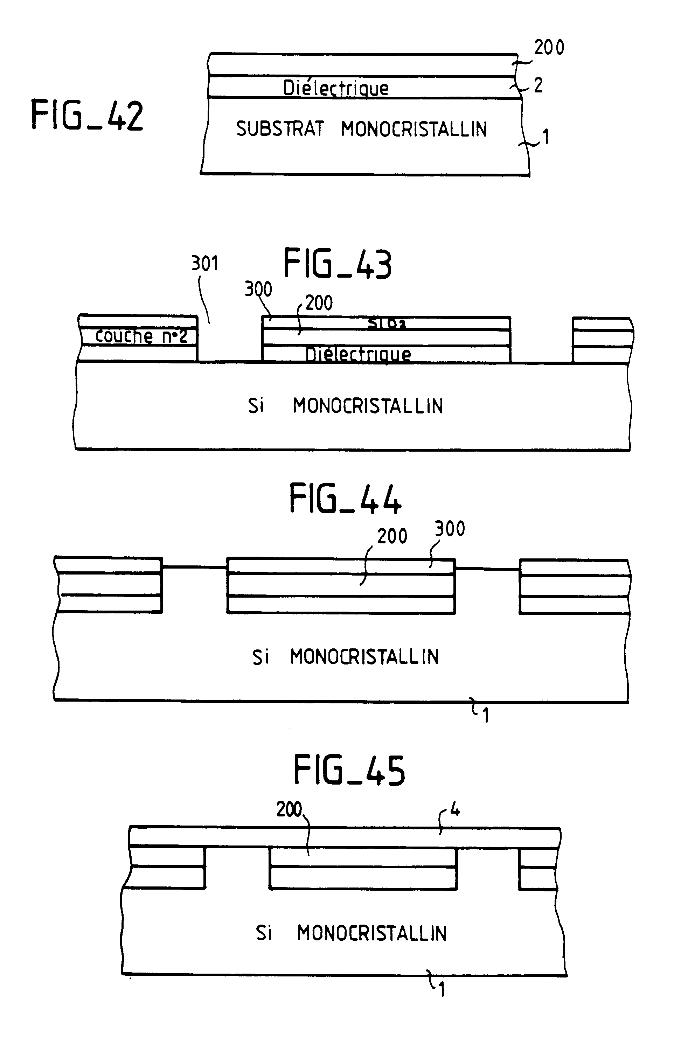

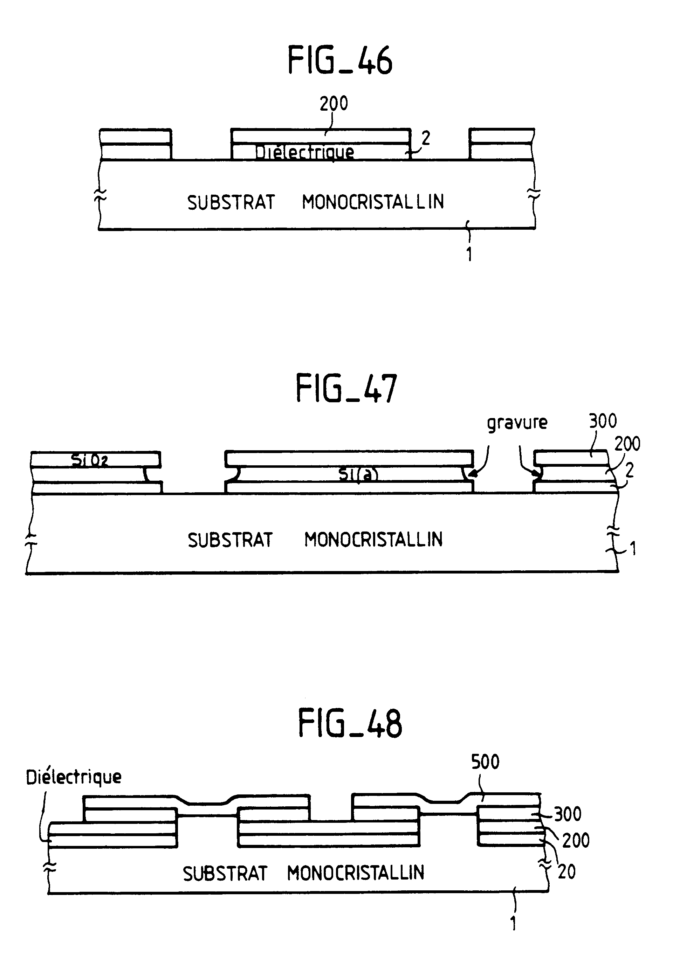

Selon une première version, on réalise l'étape de dépôt d'un premier diélectrique 2 décrite précédemment (étape 1 du procédé général), avec des substrats de départ soit Si soit GaAs ou InP etc..., d'orientation appropriée, par exemple (100). L'étape 2 de gravure n'est pas effectuée.
Etape A-3 : On dépose une deuxième couche 200 d'un matériau non nécessairement diélectrique, mais de nature différente de celle du matériau déposé lors de l'étape 1 (par exemple, si la couche déposée lors de l'étape 1 est de la silice, la couche déposée lors de cette étape 3 pourra être du nitrure de silicium Si₃N₄ ou bien du tungstène W ou bien tout autre matériau susceptible de présenter une sélectivité d'attaque chimique par rapport à la couche déposée lors de l'étape 1, en l'occurence la silice). L'épaisseur de cette deuxième couche sera du même ordre de grandeur que la première. On obtient donc la structure représentée sur la figure 42.
   A partir de cette situation, on peut envisager quatre sous variantes.
   -Une première sous variante, concerne spécifiquement un substrat 1 en silicium.
Etape A-4-1 : On dépose une couche de silice Si0₂ d'épaisseur 10⁻² à quelques micromètres.
Etape A-5-1: On grave dans la structure multicouche précédemment obtenue, un ensemble de bandes 301 de largeur 0,5 à quelques micromètres et espacées de quelques micromètres à quelques centaines de micromètres, qui mettent périodiquement à nu le substrat monocristallin comme cela est représenté en figure 43.
Etape A-6-1 : On remplit, par dépôt CVD sélectif de silicium jusqu'au niveau du milieu de la couche supérieure de silice les ouvertures 301 précédemment obtenues et ce, en utilisant des conditions d'épitaxie sélective telles que décrites précédemment (voir figure 44).
Etape A-7-1: On oxyde le silicium déposé lors de l'étape précédente de façon à "planariser" la structure (voir figure 45).
Etape A-8-1: On grave dans la silice supérieur des ouvertures décalées par rapport aux précédentes de façon à obtenir une structure similaire à celle obtenue au cours de la cinquième étape du procédé principal décrit précédemment et représentée en figure 7.

A partir de là, on reproduit la sixième étape précédente en dissolvant par attaque chimique sélective la couche 200, de façon à mettre à nu les germes de silicium monocristallin. On répète ensuite la septième étape de croissance latérale décrite précédemment, de façon à obtenir une structure similaire à celle de la figure 9 ; on réalise ensuite aisément les étapes correspondant aux figures 10 à 14 incluses.

Selon une deuxième sous variante on réalise les étapes suivantes :
Etape A-4-2 : On grave dans la structure sandwich représentée en figure 42 un ensemble de bandes, de même que lors de l'étape A-5-1 précédente. On obtient une structure du type représentée en figure 46.
Etape A-5-2: On remplit les bandes obtenues à l'étape précédente par épitaxie sélective du semiconducteur voulu (Si, GaAs, InP, etc...) de façon à planariser la structure. Etape A-6-2: On dépose sur la structure précédente une couche uniforme 4 d'un matériau diélectrique ou non, mais qui présente les caractéristiques suivantes :
   - il permet l'attaque sélective de la couche n°2.
   - il permet le dépôt sélectif du matériau semiconducteur voulu, c'est-à-dire qu'il présente a priori vis à vis de la phase gazeuse mère une barrière du nucléation plus élevée que les germes de matériau semiconducteur monocristallin obtenus lors de l'étape A-5-2.

La structure obtenue est représentée sur la figure 45 où le substrat 1 est un semiconducteur monocristallin quelconque et ou l'on remplace la couche 4 de silice supérieure par une couche de matériau dont on a énoncé les caractéristiques ci-dessus. A partir de cette étape, on répète les cinquième (ouverture de bandes type 43, 44, 45), sixième (dissolution de la couche 200), septième étapes (croissance latérale forcée en conditions d'épitaxie sélective) et suivantes du procédé principal de façon à obtenir des couches minces et des empilements de couches minces isolées, comme représenté par exemple sur les figures 31, 32 et 14.

Selon une troisième sous variante , pour diverses raisons de planéité et de rugosité superficielle optimales, il peut être intéressant de déposer lors de l'étape A-3 du silicium amorphe comme couche 200, en particulier si le substrat monocristallin est à même de supporter des températures élevées (températures d'oxydation du Si). Après ce dépôt, on opère une oxydation de la partie supérieure du silicium amorphe, de façon à obtenir après gravure de bandes une structure similaire à celle représentée sur la figure 47.

On remarquera sur cette figure 47 que l'on a légèrement sous gravé la structure en silicium amorphe.

En effet, lors de l'opération d'oxydation (à typiquement 1000°C) de la couche de silicium amorphe (déposée typiquement à 450°C) cette dernière recristallise, pour donner du silicium polycristallin, l'interface Si/Si0₂ conservant toutefois une très faible rugosité.

Ainsi, lors de l'opération de remplissage sélectif des bandes de germination (étape A-6-1 ou étape A-5-2), afin d'éviter une croissance latérale parasite gênante à partir des germes de silicium amorphe transformé en polycristallin on préfère sous graver légèrement la couche de silicium amorphe 200 transformé en polycristallin. De cette façon, la croissance verticale dans les bandes de germination n'est pas géné par des excroissances latérales à partir des germes polycristallins, étant entendu que la sous gravure est effectuée de façon telle que le front de croissance verticale arrive à l'interface Si/Si0₂ de la couche 300 avant que le front de croissance latéral issu des germes polycristallins n'ait rejoint les parois latérales des bandes de germination.

Après avoir rempli sélectivement les bandes de germination avec du matériau monocristallin, on répète les étapes A-7-1, etc... décrites précédemment si le matériau semiconducteur voulu est du silicium.

La quatrième sous variante généralise la précédente à tout autre semiconducteur que du silicium, avec utilisation de silicium ou un autre semiconducteur amorphe comme couche 200.

On dépose sur la structure de la figure 42 (où la couche 200 est du silicium ou du semiconducteur amorphe) une couche 300 de matériau présentant d'une part une excellente sélectivité d'attaque par rapport au silicium ou autre semiconducteur amorphe et d'autre part permettant le dépôt sélectif du matériau semiconducteur voulu, c'est-à-dire présentant a priori une barrière de nucléation plus élevée que la surface ou les principaux plans cristallographiques du substrat semiconducteur 1. On grave ensuite des bandes de germination pour obtenir une structure similaire à celle de la figure 47 dans laquelle le silicium ou le semiconducteur amorphe aura aussi été sous gravé.

On dépose par épitaxie sélective le matériau semiconducteur de nature différente de celle du substrat dans les bandes de germination, de façon à ne remplir que très partiellement la partie correspondant à la couche 300. Une structure similaire est représentée à la figure 44. On redépose sur l'ensemble une couche passivante 500, qui peut être du matériau tel que celui de la couche 300 ou bien tout autre matériau permettant d'obtenir des conditions de non nucléation superficielle. On ouvre enfin des bandes dans le matériau de la couche 500 (de même que lors de la cinquième l'étape du procédé général), de façon telle qu'elle soient décalées par rapport aux bandes de germination (voir figure 48).

A partir de là, on peut réaliser de même que précédemment décrit, les opérations de dissolution chimique du silicium ou du semiconducteur amorphe (couche 200) et de croissance latérale du semiconducteur monocristallin de nature différente ou non de celle du substrat à partir des germes mis à nu (sixième et septième étapes du procédé général).

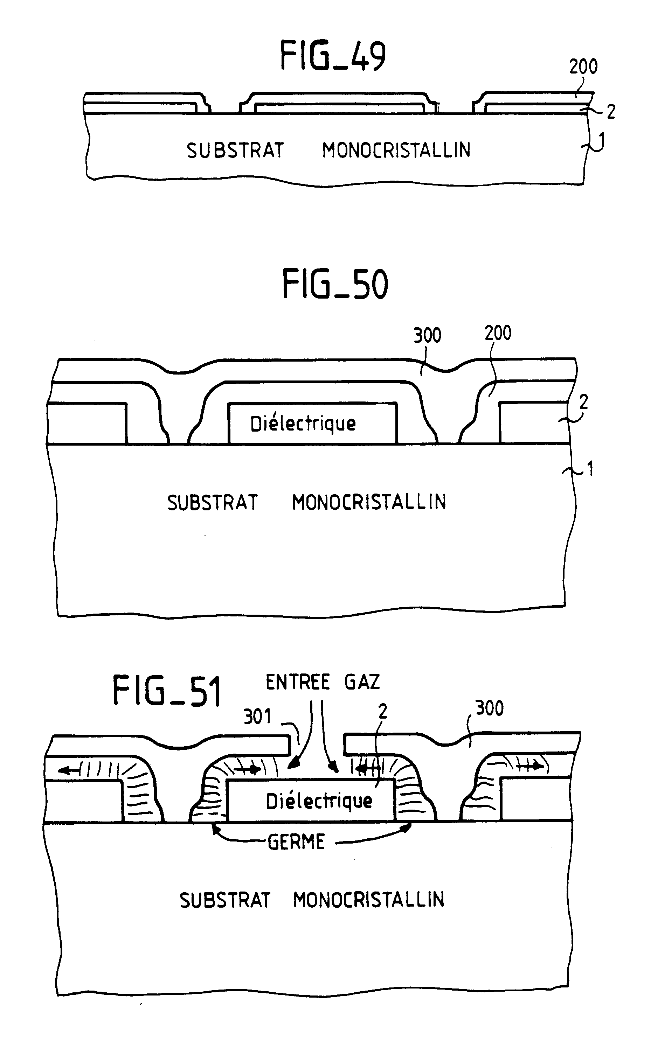

Selon une autre version, on commence par réaliser les première et deuxième étapes du procédé général. On réalise ensuite les étapes suivantes :
Etape B-3: On dépose une couche 200 uniforme d'un matériau qui présente une excellente sélectivité d'attaque chimique par rapport au diélectrique d'une part et à la couche 300 (dont la description va suivre) d'autre part. Cette couche 200 peut être du silicium amorphe, un diélectrique, un métal ou bien du polyimide ou équivalent.
Etape B-4 : On grave dans la couche précédente un système de bandes, de façon à mettre le substrat à nu dans les espaces laissés libres par la gravure du premier système de bandes. La situation est représentée sur la figure 49.
   On s'est arrangé pour que les ouvertures effectuées dans la couches 200 soient de largeur inférieure à celle des premières et symétriquement disposées au milieu de ces mêmes premières.
Etape B-5: On redépose sur la structure précédente une couche 300 uniforme d'un matériau présentant une excellente sélectivité d'attaque chimique avec le matériau 200 et présentant de plus vis à vis de la phase gazeuse "mère" une barrière de nucléation plus élevée que les principaux plans cristallographiques du substrat. La situation est schématisée sur la figure 50.
   A partir de cette situation, on répète la cinquième étape du procédé général. On dissout la couche 200 selon la sixième étape du procédé général et on refait croître en conditions d'épitaxie sélective, à partir du germe constitué par la face supérieure du substrat, une couche mince du matériau semiconducteur voulu selon la septième étape de ce même procédé général (voir figure 51).

## Revendications

1. Procédé de réalisation d'une couche mince en matériau semiconducteur monocristallin, caractérisé en ce qu'il comporte :
- la réalisation d'une cavité (30) délimitée par deux couches de confinement (20, 40) en matériau distinct de celui de la couche mince monocristalline à obtenir de telle façon que, lors d'une croissance, il ne pourra y avoir ni nucléation, ni dépôt du matériau semiconducteur sur les surfaces exposées des couches de confinement, ladite cavité s'étendant selon deux directions principales perpendiculaires, l'une étant parallèle aux surfaces des couches de confinement, et l'autre perpendiculaire à celles-ci, et comportant, à une extrémité, un élément ou germe (38) en matériau semiconducteur monocristallin du même type que celui de la couche mince à obtenir et, à une autre extrémité, une ouverture (43, 44) ;
- croissance en phase vapeur du matériau semiconducteur entre les deux couches de confinement (20, 40), par l'ouverture (43, 44), à partir du germe (38) de façon à obtenir une couche en matériau semiconducteur monocristallin, la croissance ayant lieu dans ladite cavité d'abord selon la direction parallèle aux surfaces des couches de confinement.

2. Procédé de réalisation selon la revendication 1, d'une couche de matériau semiconducteur monocristallin sur une première couche d'un matériau isolant (2) réalisée sur un substrat (1) semiconducteur monocristallin, caractérisé en ce qu'il comporte les étapes suivantes :
a) une première étape de réalisation sur le substrat (1) semiconducteur monocristallin de ladite première couche de matériau isolant (2) présentant une sélectivité d'attaque chimique par rapport aux couches adjacentes et ne permettant ni nucléation, ni dépôt à partir des espèces de ladite phase vapeur sur sa surface exposée à la phase vapeur ;
b) une deuxième étape de gravure de premières ouvertures (23, 24) dans la première couche (2) de matériau isolant ;
c) une troisième étape de réalisation dans les premières ouvertures (23, 24), et sur les parties de la couche d'isolant (20, 21, 22) restant après l'étape de gravure précédente, d'une couche d'un matériau semiconducteur (30 à 34), cette couche étant monocristalline dans les ouvertures (23, 24) et polycristalline sur l'isolant (20, 21, 22);
d) une quatrième étape de réalisation d'une deuxième couche (4) d'un matériau isolant sur la couche de matériau semiconducteur (30 à 34) ;
e) une cinquième étape de gravure dans la deuxième couche (4) de matériau isolant d'au moins une deuxième ouverture (43, 44) aboutissant sur une partie polycristalline (30, 31, 32) de la couche de matériau semiconducteur (30 à 34) ;
f) une sixième étape d'attaque chimique du matériau semiconducteur polycristallin (30, 31, 32) de façon à supprimer tout le matériau semiconducteur polycristallin et, éventuellement, à légèrement attaquer le matériau monocristallin;
g) une septième étape de croissance sélective à partir d'une phase vapeur d'un matériau semiconducteur monocristallin dans le ou les espaces (30, 31, 32) laissés libres par la disparition du matériau polycristallin.

3. Procédé selon la revendication 2 caractérisé en ce qu'il comporte :
- une huitième étape d'oxydation ou de gravure localisée du matériau semiconducteur monocristallin situé dans la ou les deuxièmes ouvertures (43, 44) situées dans la deuxième couche de matériau isolant (4) présentant une sélectivité d'attaque chimique par rapport aux couches adjacentes et ne permettant ni nucléation, ni dépôt à partir des espèces de ladite phase vapeur sur ses surfaces exposées à la phase vapeur ;
- une neuvième étape de retrait de la couche de matériau isolant (40, 41, 42) et du matériau semiconducteur monocristallin oxydé (43, 44).

4. Procédé selon la revendication 3 caractérisé en ce qu'il comporte :
- une dixième étape d'oxydation localisée du matériau semiconducteur monocristallin (30, 31) dans des zones correspondant aux premières ouvertures (33, 34).

5. Procédé selon la revendication 4, caractérisé en ce qu'il comporte ;
une onzième étape d'attaque du matériau semiconducteur oxydé au cours de la dixième étape.

6. Procédé selon la revendication 2 caractérisé en ce que la septième étape (g) de croissance de matériau semiconducteur monocristallin est arrêtée lorsque ce matériau atteint les flancs des deuxièmes ouvertures (43, 44) et en ce qu'il comporte les phases suivantes après la septième étape :
- une première phase d'attaque et d'élimination de l'isolant de la deuxième couche de matériau isolant (4) ;
- une deuxième phase de dépôt d'un matériau intercalaire, présentant une sélectivité d'attaque chimique par rapport à la première couche de matériau isolant (2) et à une troisième couche d'isolant (5) qui sera déposée ultérieurement, dans les ouvertures (43) existant dans la couche de matériau monocristallin (30, 31, 32), et une planarisation de la structure obtenue ;
- une troisième phase de dépôt d'une troisième couche d'isolant (5) ;
- une quatrième phase de gravure de troisièmes ouvertures (53) dans la troisième couche d'isolant (5) au dessus du matériau intercalaire ;
- une cinquième phase d'enlèvement du matériau intercalaire par les troisièmes ouvertures (53) ;
- une sixième phase de croissance et d'épitaxie sélectives de matériau semiconducteur monocristallin par les troisièmes ouvertures (53).

7. Procédé selon la revendication 1, caractérisé en ce que lesdites ouvertures sont réalisées sous forme de bandes.

8. Procédé selon l'une quelconque des revendications 1 à 7 caractérisé en ce que chaque étape ou phase d'attaque ou d'enlèvement est suivie d'une étape de décapage.

9. Procédé selon la revendication 2, caractérisé en ce que le substrat est du silicium de l'arséniure de gallium (GaAs) du phosphure d'indium (InP), un composé III-V ou un composé II-VI et que le matériau semiconducteur est de même nature.

10. Procédé selon la revendication 9 caractérisé en ce que l'isolant est de la silice (Si O₂) ou du nitrure de silicium (Si₃ N₄).

11. Procédé selon la revendication 2, caractérisé en ce que lors de la septième étape, est réalisée de façon à ce qu'il y ait débordement du matériau semiconducteur au dessus du matériau isolant et que cette septième étape est suivie d'une phase de polissage mécano-chimique du semiconducteur jusqu'à atteindre la surface du matériau isolant, le polissage s'arrêtant alors automatiquement par sélectivité du réactif chimique utilisé.

12. Procédé selon la revendication 2, caractérisé en ce que les ouvertures (23, 24) réalisées lors de la troisième étape sont orientées de façon à ce que la facette de croissance latérale réalisée lors de la septième étape ne soit pas limitante.

13. Procédé selon la revendication 3, caractérisé en ce qu'il comporte une dixième étape de gravure localisée du matériau semiconducteur monocristallin (30, 31) dans des zones correspondant sensiblement aux premières ouvertures (33, 34).

14. Procédé selon la revendication 1, caractérisé en ce qu'il comporte les étapes suivantes :
- une première étape de réalisation de mésas (80, 83) d'une hauteur déterminée dans un substrat semiconducteur monocristallin ;
- une deuxième étape de dépôt, sur le substrat entre les mésas (80) d'un matériau diélectrique (91, 92) dont l'épaisseur est inférieure à la hauteur des mésas ;
- une troisième étape de dépôt sur le matériau diélectrique (91, 92) d'un matériau intercalaire (101, 102) présentant une sélectivité d'attaque chimique par rapport au matériau diélectrique (90, 91, 92) et à la couche (110) de matériau supérieur qui sera déposée ultérieurement dont l'épaisseur est telle que son addition à l'épaisseur du matériau diélectrique (91, 92) permet d'égaler la hauteur des mésas ;
- une quatrième étape de dépôt sur l'ensemble des mésas (80, 83) et du matériau intercalaire (101, 102) d'une couche (110) d'un matériau encapsulant présentant une sélectivité d'attaque chimique par rapport à la couche de matériau intercalaire et ne permettant ni nucléation, ni dépôt à partir des espèces de ladite phase vapeur sur les surfaces exposées dudit matériau encapsulant ;
- une cinquième étape de réalisation d'ouvertures (43, 44) dans la couche (110) de matériau encapsulant dans des zones aboutissant sur du matériau intercalaire (101, 102) ;
- une sixième étape d'elimination, par les ouvertures (43, 44), du matériau intercalaire (101, 102) ;
- une septième étape de croissance sélective en phase vapeur par les ouvertures (43, 44), d'un matériau semiconducteur monocristallin de même nature que le substrat.

15. Procédé selon la revendication 14, caractérisé en ce que le substrat est en silicium (Si) en arséniure de gallium (GaAs), ou en phosphure d'indium (InP), ou est un composé de type III-V ou un composé de type II-VI.

16. Procédé selon la revendication 1, caractérisé en ce qu'il comporte les étapes suivantes :
- une première étape de réalisation sur un substrat semiconducteur monocristallin d'au moins une bande constituée d'une couche d'un matériau diélectrique (2), d'une couche d'un matériau intercalaire semiconducteur (200) et d'une couche d'un matériau encapsulant (300) isolant présentant une sélectivité d'attaque chimique par rapport aux couches adjacentes et ne permettant ni nucléation, ni dépôt à partir des espèces de ladite phase vapeur sur ses surfaces exposées à la phase vapeur ;
- une deuxième étape de croissance sur le substrat (1), dans les zones (301) non occupées par ladite bande, d'un matériau semiconducteur monocristallin ;
- une troisième étape d'oxydation de ce matériau semiconducteur monocristallin ;
- une quatrième étape de réalisation d'ouvertures dans la couche encapsulante (300) présentant une sélectivité d'attaque chimique par rapport aux couches adjacentes et ne permettant ni nucléation, ni dépôt à partir des espèces de ladite phase vapeur sur sa surface exposé à la phase vapeur ;
- une cinquième étape d'élimination par lesdites ouvertures de la couche de matériau intercalaire semiconducteur (200) ;
- une sixième étape de croissance sélective, par lesdites ouvertures d'un matériau semiconducteur monocristallin.

17. Procédé selon la revendication 16, caractérisé en ce que la première étape prévoit la réalisation sur le substrat d'une bande ne comportant qu'une couche d'un matériau diélectrique (2) et d'une couche d'un matériau intercalaire semiconducteur (200) et que la troisième étape prévoit le dépôt d'une couche encapsulante (300) présentant une sélectivité d'attaque chimique par rapport aux couches adjacentes et ne permettant ni nucléation, ni dépôt à partir des espèces de ladite phase vapeur sur sa surface exposée à la phase vapeur sur l'ensemble de la structure.

18. Procédé selon la revendication 17, caractérisé en ce que la deuxième étape prévoit une phase préalable de gravure de la couche de matériau intercalaire semiconducteur (200).

19. Procédé selon la revendication 1 caractérisé en ce qu'il comporte les étapes suivantes :
- une première étape de réalisation, sur un substrat (1), d'au moins une bande de matériau diélectrique (2) ;
- une deuxième étape de revêtement de ces bandes (2) par un matériau intercalaire semiconducteur (200) présentant une sélectivité d'attaque chimique par rapport aux autres matériaux ;
- une troisième étape de revêtement de l'ensemble ainsi obtenu par un matériau encapsulant (300) présentant une sélectivité d'attaque chimique par rapport aux couches adjacentes et ne permettant ni nucléation, ni dépôt à partir des espèces de ladite phase vapeur sur sa surface exposée à la phase vapeur ;
- une quatrième étape de réalisation d'ouvertures dans le matériau encapsulant (300) au dessus de la bande de matériau diélectrique 2 ;
- une cinquième étape d'élimination, par les ouvertures (301), du matériau intercalaire semiconducteur (200) ;
- une sixième étape de croissance et d'épitaxie sélectives par les ouvertures (301), d'un matériau semiconducteur monocristallin.

20. Procédé selon l'une quelconque des revendications 1 à 5, caractérisé en ce qu'il comporte ensuite la réalisation d'au moins une cavité (3000) de volume limité par un matériau distinct du matériau semiconducteur laquelle cavité communique avec une couche de matériau semiconducteur (30) déjà réalisée de façon à réaliser au moins une autre croissance d'une couche mince monocristalline d'un matériau semiconducteur à partir de la couche de matériau semiconducteur (30) déjà réalisée.

21. Procédé selon la revendication 14, caractérisé en ce que le matériau intercalaire (101, 102) est organique.

22. Procédé selon la revendication 21 caractérisé en ce que le matériau intercalaire (101, 102) est un polyimide ou un polymère.

23. Procédé selon la revendication 14, caractérisé en ce que le matériau intercalaire (101, 102) est minéral.

## Claims

1. Method for producing a thin layer made of monocrystalline semiconductor material, characterized in that it comprises:
- the production of a cavity (30) delimited by two confinement layers (20, 40) made of material other than that of the monocrystalline thin layer to be obtained, in such a way that, during growth, it will be possible for there to be neither nucleation nor deposition of the semiconductor material onto the exposed surfaces of the confinement layers, the said cavity extending along two main perpendicular directions, one being parallel to the surfaces of the confinement layers, and the other perpendicular to the latter, and comprising, at one end, an element or seed (38) made of monocrystalline semiconductor material of the same type as that of the thin layer to be obtained and, at another end, an opening (43, 44);
- vapour-phase growth of the semiconductor material between the two confinement layers (20, 40), through the opening (43, 44), from the seed (38) so as to obtain a layer made of monocrystalline semiconductor material, the growth taking place in the said cavity firstly along the direction parallel to the surfaces of the confinement layers.

2. Method according to Claim 1 for producing a layer of monocrystalline semiconductor material on a first layer of an insulating material (2) produced on a monocrystalline semiconductor substrate (1), characterized in that it comprises the following steps:
- a) a first step of producing, on the monocrystalline semiconductor substrate (1), the said first layer (2) of insulating material exhibiting chemical-etching selectivity with respect to the adjacent layers and permitting neither nucleation nor deposition from the species of the said vapour phase onto its surface exposed to the vapour phase:
- b) a second step of etching first openings (23, 24) in the first layer (2) of insulting material;
- c) a third step of producing, in the first openings (23, 24), and on those parts of the insulating layer (20, 21, 22) remaining after the preceding etching step, a layer (30 to 34) of a semiconductor material, this layer being monocrystalline in the openings (23, 24) and polycrystalline on the insulation (20, 21, 22);
- d) a fourth step of producing a second layer (4) of an insulating material on the layer (30 to 34) of semiconductor material;
- e) a fifth step of etching, in the second layer (4) of insulating material, at least one second opening (43, 44) ending up on a polycrystalline part (30, 31, 32) of the layer (30 to 34) of semiconductor material;
- f) a sixth step of chemically etching the polycrystalline semiconductor material (30, 31, 32) so as to eliminate all the polycrystalline semiconductor material and, possibly, to etch the monocrystalline material slightly;
- g) a seventh step of selective growth from a vapour phase of a monocrystalline semiconductor material in the space or spaces (30, 31, 32) left free by the disappearance of the polycrystalline material.

3. Method according to Claim 2, characterized in that it comprises:
- an eighth step of oxidizing or locally etching the monocrystalline semiconductor material located in the second opening or openings (43, 44) located in the second layer (4) of insulating material exhibiting chemical-etching selectivity with respect to the adjacent layers and permitting neither nucleation nor deposition from the species of the said vapour phase onto its surfaces exposed to the vapour phase;
- a ninth step of removing the layer (40, 41, 42) of insulating material and the oxidized monocrystalline semiconductor material (43, 44).

4. Method according to Claim 3, characterized in that it comprises:
- a tenth step of locally oxidizing the monocrystalline semiconductor material (30, 31) in zones corresponding to the first openings (33, 34).

5. Method according to Claim 4, characterized in that it comprises:
- an eleventh step of etching the semiconductor material oxidized during the tenth step.

6. Method according to Claim 2, characterized in that the seventh step (g) of growth of monocrystalline semiconductor material is stopped when this material reaches the side walls of the second openings (43, 44) and in that it comprises the following phases after the seventh step:
- a first phase of etching and eliminating the insulation of the second layer (4) of insulating material;
- a second phase of depositing an intermediate material, exhibiting chemical-etching selectivity with respect to the first layer (2) of insulating material and to a third insulating layer (5) which will be deposited subsequently, in the openings (43) existing in the layer (30, 31, 32) of monocrystalline material, and planarization of the structure obtained;
- a third phase of depositing a third insulating layer (5);
- a fourth phase of etching third openings (53) in the third insulating layer (5) above the intermediate material;
- a fifth phase of removing the intermediate material through the third openings (53);
- a sixth phase of selective growth and selective epitaxy of monocrystalline semiconductor material through the third openings (53).

7. Method according to Claim 1, characterized in that the said openings are produced in the form of strips.

8. Method according to any one of Claims 1 to 7, characterized in that each etching or removal step or phase is followed by a cleaning step.

9. Method according to Claim 2, characterized in that the substrate is silicon, gallium arsenide (GaAs), indium phosphide (InP), a III-V compound or a II-VI compound and that the semiconductor material is of the same kind.

10. Method according to Claim 9, characterized in that the insulation is silica (SiO₂) or silicon nitride (Si₃N₄).

11. Method according to Claim 2, characterized in that, during the seventh step, is carried out so that there is overhang of the semiconductor material above the insulating material and that this seventh step is followed by a phase of mechanochemical polishing of the semiconductor until reaching the surface of the insulating material, the polishing then stopping automatically by selectivity of the chemical reagent used.

12. Method according to Claim 2, characterized in that the openings (23, 24) produced during the third step are oriented so that the lateral growth facet produced during the seventh step is not limiting.

13. Method according to Claim 3, characterized in that it comprises a tenth step of localized etching of the monocrystalline semiconductor material (30, 31) in zones substantially corresponding to the first openings (33, 34).

14. Method according to Claim 1, characterized in that it comprises the following steps:
- a first step of producing mesas (80, 83) of a defined height in a monocrystalline semiconductor substrate;
- a second step of depositing, onto the substrate, between the mesas (80), a dielectric material (91, 92), the thickness of which is less than the height of the mesas;
- a third step of depositing, onto the dielectric material (91, 92), an intermediate material (101, 102) exhibiting chemical-etching selectivity with respect to the dielectric material (90, 91, 92) and to the layer (110) of upper material which will be deposited subsequently, the thickness of which is such that its addition to the thickness of the dielectric material (91, 92) enables the height of the mesas to be made the same;
- a fourth step of depositing, onto all the mesas (80, 83) and onto the intermediate material (101, 102), a layer (110) of an encapsulating material exhibiting chemical-etching selectivity with respect to the layer of intermediate material and permitting neither nucleation nor deposition from the species of the said vapour phase onto the exposed surfaces of said encapsulating material;
- a fifth step of producing openings (43, 44) in the layer (110) of encapsulating material in zones ending up on intermediate material (101, 102);
- a sixth step of eliminating the intermediate material (101, 102) through the openings (43, 44);
- a seventh step of selective vapour-phase growth of a monocrystalline semiconductor material, of the same kind as the substrate through the openings (43, 44).

15. Method according to Claim 14, characterized in that the substrate is made of silicon (Si), gallium arsenide (GaAs) or indium phosphide (InP), or is a compound of the III-V type or a compound of the II-VI type.

16. Method according to Claim 1, characterized in that it comprises the following steps:
- a first step of producing, on a monocrystalline semiconductor substrate, at least one strip consisting of a layer (2) of a dielectric material, a layer (200) of a semiconductor intermediate material and a layer (300) of an insulating encapsulating material exhibiting chemical-etching selectivity with respect to the adjacent layers and permitting neither nucleation nor deposition from the species of the said vapour phase onto its surfaces exposed to the vapour phase;
- a second step of growth of a monocrystalline semiconductor material on the substrate (1) in the zones (301) not occupied by the said strip;
- a third step of oxidizing this monocrystalline semiconductor material;
- a fourth step of producing openings in the encapsulating layer (300) exhibiting chemical-etching selectivity with respect to the adjacent layers and permitting neither nucleation nor deposition from the species of the said vapour phase onto its surface exposed to the vapour phase;
- a fifth step of eliminating the layer (200) of semiconductor intermediate material through the said openings;
- a sixth step of selective growth of a monocrystalline semiconductor material through the said openings.

17. Method according to Claim 16, characterized in that the first step provides for the production, on the substrate, of a strip comprising only one layer (2) of a dielectric material and of a layer (200) of a semiconductor intermediate material and in that the third step provides for the deposition of an encapsulating layer (300) exhibiting chemical-etching selectivity with respect to the adjacent layers and permitting neither nucleation nor deposition from the species of the said vapour phase onto its surface exposed to the vapour phase over the whole of the structure.

18. Method according to Claim 17, characterized in that the second step provides for a prior phase of etching the layer (200) of semiconductor intermediate material.

19. Method according to Claim 1, characterized in that it comprises the following steps:
- a first step of producing, at least one strip (2) of dielectric material on a substrate (1);
- a second step of coating these strips (2) with a semiconductor intermediate material (200) exhibiting chemical-etching selectivity with respect to the other materials;
- a third step of coating the whole assembly thus obtained with an encapsulating material (300) exhibiting chemical-etching selectivity with respect to the adjacent layers and permitting neither nucleation nor deposition from the species of the said vapour phase onto its surface exposed to the vapour phase;
- a fourth step of producing openings in the encapsulating material (300) above the strip (2) of dielectric material;
- a fifth step of eliminating the intermediate semiconductor material (200) through the openings (301);
- a sixth step of selective growth and selective epitaxy of a monocrystalline semiconductor material through the openings (301).

20. Method according to any one of Claims 1 to 5, characterized in that it comprises thereafter the production of at least one cavity (3000) of volume bounded by a material other than the semiconductor material, which cavity communicates with a layer (30) of semiconductor material already produced so as to carry out at least one other growth of a thin monocrystalline layer of a semiconductor material from the layer (30) of semiconductor material already produced.

21. Method according to Claim 14, characterized in that the intermediate material (101, 102) is organic.

22. Method according to Claim 21, characterized in that the intermediate material (101, 102) is a polyimide or a polymer.

23. Method according to Claim 14, characterized in that the intermediate material (101, 102) is inorganic.

## Patentansprüche

1. Verfahren zur Herstellung einer dünnen Schicht aus einem monokristallinen Halbleitermaterial, dadurch gekennzeichnet, daß es folgende Schritte aufweist:
- Herstellung eines von zwei Begrenzungsschichten (20, 40) abgegrenzten Hohlraums (30) aus einem zu demjenigen der dünnen monokristallinen Schicht unterschiedlichen Material, der so zu erhalten ist, daß bei einem Wachstum weder eine Nukleation noch eine Abscheidung des Halbleitermaterials an den exponierten Flächen der Begrenzungsschichten auftreten kann, wobei sich der Hohlraum in zwei senkrechten Hauptrichtungen erstreckt, von denen eine zu den Flächen der Begrenzungsschichten parallel und die andere dazu senkrecht liegt, und wobei er an einem Ende ein Element oder einen Keim (38) aus einem monokristallinen Halbleitermaterial des gleichen Typs wie demjenigen der zu erhaltenden dünnen Schicht sowie an dem anderen Ende eine Öffnung (43, 44) aufweist;
- Wachstum des Halbleitermaterials in der Dampfphase zwischen den beiden Begrenzungsschichten (20, 40) durch die Öffnung (43, 44) ausgehend von dem Keim (38), so daß eine Schicht aus einem monokristallinen Halbleitermaterial erhalten wird, wobei das Wachstum zunächst in der zu den Flächen der Begrenzungsschichten parallelen Richtung stattfindet.

2. Herstellungsverfahren nach Anspruch 1 für eine Schicht aus monokristallinem Halbleitermaterial auf einer ersten Schicht aus einem Isoliermaterial (2), die auf einem monokristallinen Halbleitersubstrat (1) hergestellt ist, dadurch gekennzeichnet, daß es die folgenden Schritte aufweist:
a) einen ersten Schritt der Herstellung der ersten Schicht aus Isoliermaterial (2) auf dem monokristallinen Halbleitersubstrat (1), die eine chemische Angriffsselektivität gegenüber den angrenzenden Schichten aufweist und weder eine Nukleation noch eine Abscheidung ausgehend von den Spezies der Dampfphase an ihrer der Dampfphase ausgesetzten Fläche zuläßt;
b) einen zweiten Schritt des Ätzens von ersten Öffnungen (23, 24) in der ersten Schicht (2) aus Isoliermaterial;
c) einen dritten Schritt der Herstellung einer Schicht aus einem Halbleitermaterial (30 bis 34) in den ersten Öffnungen (23, 24) sowie auf den Teilen der Isolierstoffschicht (20, 21, 22), die nach dem vorhergehenden Ätzschritt übrigbleiben, wobei diese Schicht in den Öffnungen (23, 24) monokristallin und auf dem Isolierstoff (20, 21, 22) polykristallin ist.;
d) einen vierten Schritt der Herstellung einer zweiten Schicht (4) aus einem Isoliermaterial auf der Schicht aus Halbleitermaterial (30 bis 34);
e) einen fünften Schritt des Ätzens wenigstens einer zweiten Öffnung (43, 44) in der zweiten Schicht (4) aus Isoliermaterial, die an einem polykristallinen Teil (30, 31, 32) der Schicht aus Halbleitermaterial (30 bis 34) mündet;
f) einen sechsten Schritt eines chemischen Angriffs auf das polykristalline Halbleitermaterial (30, 31, 32), so daß das gesamte polykristalline Halbleitermaterial abgebaut und möglicherweise das monokristalline Material leicht angegriffen wird;
g) einen siebten Schritt des selektiven Wachstums eines monokristallinen Halbleitermaterials aus einer Dampfphase in dem oder den durch das Verschwinden des polykristallinen Materials freigelassenen Räumen (30, 31, 32).

3. Verfahren nach Anspruch 2, dadurch gekennzeichnet, daß es aufweist:
- einen achten Schritt der Oxidation oder des lokalisierten Ätzens des monokristallinen Halbleitermaterials in der oder den zweiten Öffnungen (43, 44), die in der zweiten Schicht aus Isoliermaterial (4) liegen, die eine chemische Angriffsselektivität bezüglich der angrenzenden Schichten aufweist und weder eine Nukleation noch eine Abscheidung ausgehend von den Spezies der Dampfphase an ihren der Dampfphase ausgesetzten Flächen zuläßt;
- einen neunten Schritt der Beseitigung der Schicht aus Isoliermaterial (40, 41, 42) und des oxidierten monokristallinen Halbleitermaterials (43, 44).

4. Verfahren nach Anspruch 3, dadurch gekennzeichnet, daß es aufweist:
- einen zehnten Schritt der lokalisierten Oxidation des monokristallinen Halbleitermaterials (30, 31) in den ersten Öffnungen (33, 34) entsprechenden Zonen.

5. Verfahren nach Anspruch 4, dadurch gekennzeichnet, daß es aufweist:
- einen elften Schritt des Angriffs auf das im Verlauf des zehnten Schritts oxidierte Halbleitermaterial.

6. Verfahren nach Anspruch 2, dadurch gekennzeichnet, daß der siebte Schritt (g) des Wachstums von monokristallinem Halbleitermaterial angehalten wird, wenn dieses Material die Flanken der zweiten Öffnungen (43, 44) erreicht, und daß es nach dem siebten Schritt die folgenden Phasen aufweist:
- eine erste Phase des Angriffs und der Beseitigung des Isolierstoffs der zweiten Schicht aus Isoliermaterial (4);
- eine zweite Phase des Aufbringens eines Zwischenmaterials, das eine chemische Angriffselektivität bezüglich der ersten Schicht aus Isoliermaterial (2) und einer dritten Schicht aus Isolierstoff (5) aufweist, die später aufgebracht wird, in den Öffnungen (43), die in der Schicht (30, 31, 32) aus monokristallinem Material bestehen, sowie eine Planarisierung der erhaltenen Schicht;
- eine dritte Phase des Aufbringens einer dritten Isolierstoffschicht (5);
- eine vierte Phase des Ätzens von dritten Öffnungen (53) in der dritten Isolierstoffschicht (5) über dem Zwischenmaterial;
- eine fünfte Phase des Entfernens des Zwischenmaterials durch die dritten Öffnungen (53);
- eine sechste Phase selektiven Wachstums und selektiver Epitaxie von monokristallinem Halbleitermaterial durch die dritten Öffnungen (53).

7. Verfahren nach Anspruch 1, dadurch gekennzeichnet, daß die Öffnungen in Form von Bändern realisiert sind.

8. Verfahren nach einem der Ansprüche 1 bis 7, dadurch gekennzeichnet, daß auf jeden Schritt oder jede Phase des Angriffs oder des Entfernens ein Beizschritt folgt.

9. Verfahren nach Anspruch 2, dadurch gekennzeichnet, daß das Substrat Silicium, Galliumarsenid (GaAs), Indiumphosphid (InP), eine III-V-Verbindung oder eine II-VI-Verbindung ist, und daß das Halbleitermaterial von gleicher Beschaffenheit ist.

10. Verfahren nach Anspruch 9, dadurch gekennzeichnet, daß der Isolierstoff Siliciumdioxid (SiO₂) oder Siliciumnitrid (Si₃N₄) ist.

11. Verfahren nach Anspruch 2, dadurch gekennzeichnet, daß es beim siebten Schritt so realisiert wird, daß das Halbleitermaterial über das Isoliermaterial übersteht, und daß auf diesen siebten Schritt eine Phase des mechanisch-chemischen Polierens des Halbleiters folgt, bis die Fläche des Isoliermaterials erreicht ist, wobei das Polieren dann automatisch durch die Selektivität des verwendeten chemischen Reagenzes anhält.

12. Verfahren nach Anspruch 2, dadurch gekennzeichnet, daß die beim dritten Schritt realisierten Öffnungen (23, 24) so orientiert sind, daß die beim siebten Schritt realisierte Lateralwachstumsfacette nicht begrenzend ist.

13. Verfahren nach Anspruch 3, dadurch gekennzeichnet, daß es einen zehnten Schritt des lokalisierten Ätzens des monokristallinen Halbleitermaterials (30, 31) in Zonen aufweist, die im wesentlichen den ersten Öffnungen (33, 34) entsprechen.

14. Verfahren nach Anspruch 1, dadurch gekennzeichnet, daß es die folgenden Schritte aufweist:
- einen ersten Schritt der Herstellung von Mesas (80, 83) mit bestimmter Höhe in einem monokristallinen Halbleitersubstrat;
- einen zweiten Schritt des Aufbringens eines dielektrischen Materials (91, 92), dessen Dicke kleiner als die Höhe der Mesas ist, auf dem Substrat zwischen den Mesas (80);
- einen dritten Schritt des Aufbringen eines Zwischenmaterials (101, 102) auf dem dielektrischen Material (91, 92), das eine chemische Angriffselektivität bezüglich des dielektrischen Materials (90, 91, 92) und der Schicht (110) aus dem oberen Material aufweist, die später aufgebracht wird, und eine solche Dicke aufweist, daß durch seine Hinzufügung zu der Dicke des dielektrischen Materials (91, 92) ein Ausgleich der Höhe der Mesas ermöglicht wird;
- einen vierten Schritt des Aufbringens einer Schicht (110) aus einem einkapselnden Material auf der Einheit aus den Mesas (80, 83) und dem Zwischenmaterial (101, 102), die eine chemische Angriffsselektivität bezüglich der Schicht aus dem Zwischenmaterial aufweist und weder eine Nukleation noch eine Abscheidung ausgehend von den Spezies der Dampfphase an den exponierten Flächen des einkapselnden Materials zuläßt;
- einen fünften Schritt der Herstellung von Öffnungen (43, 44) in der Schicht (110) aus einkapselndem Material in Zonen, die an Zwischenmaterial (101, 102) angrenzen;
- einen sechsten Schritt der Beseitigung des Zwischenmaterials (101, 102) durch die Öffnungen (43, 44);
- einen siebten Schritt des selektiven Dampfphasenwachstums eines monokristallinen Halbleitermaterials der gleichen Beschaffenheit wie das Substrat durch die Öffnungen (43, 44).

15. Verfahren nach Anspruch 14, dadurch gekennzeichnet, daß das Substrat aus Silicium (Si), aus Galliumarsenid (GaAs) oder Indiumphosphid (InP) besteht oder eine Verbindung des Typs III-V oder des Typs II-VI ist.

16. Verfahren nach Anspruch 1, dadurch gekennzeichnet, daß es die folgenden Schritte aufweist:
- einen ersten Schritt der Herstellung wenigstens eines Bandes auf einem monokristallinen Halbleitersubstrat, das aus einer Schicht (2) aus einem dielektrischen Material, einer Schicht (200) aus einem Halbleiterzwischenmaterial sowie einer Schicht (300) aus einem isolierenden Einkapselungsmaterial gebildet ist, die eine chemische Angriffsselektivität bezüglich der angrenzenden Schichten aufweist und weder eine Nukleation noch eine Abscheidung ausgehend von den Spezies der Dampfphase an ihren der Dampfphase ausgesetzten Flächen zuläßt;
- einen zweiten Schritt des Wachstums eines monokristallinen Halbleitermaterials auf dem Substrat (1) in den nicht von dem Band besetzten Zonen (301);
- einen dritten Schritt der Oxidation dieses monokristallinen Halbleitermaterials;
- einen vierten Schritt der Herstellung von Öffnungen in der einkapselnden Schicht (300), die eine chemische Angriffsselektivität bezüglich der angrenzenden Schichten aufweist und weder eine Nukleation noch eine Abscheidung ausgehend von den Spezies der Dampfphase an ihrer der Dampfphase ausgesetzten Fläche zuläßt;
- einen fünften Schritt der Beseitigung der Schicht (200) aus Halbleiterzwischenmaterial durch die Öffnungen;
- einen sechsten Schritt des selektiven Wachstums eines monokristallinen Halbleitermaterials durch die Öffnungen.

17. Verfahren nach Anspruch 16, dadurch gekennzeichnet, daß der ersten Schritt die Herstellung eines Bandes auf dem Substrat vorsieht, das nur eine Schicht (2) aus einem dielektrischen Material aufweist, und einer Schicht (200) aus einem Halbleiterzwischenmaterial (200), und daß der dritte Schritt das Aufbringen einer einkapselnden Schicht (300) vorsieht, die eine chemische Angriffsselektivität bezüglich der angrenzenden Schichten aufweist und weder eine Nukleation noch eine Abscheidung ausgehend von den Spezies der Dampfphase an ihrer Fläche auf der gesamten Struktur zuläßt, die der Dampfphase ausgesetzt ist.

18. Verfahren nach Anspruch 17, dadurch gekennzeichnet, daß der zweite Schritt eine vorangehende Phase der Ätzung der Halbleiterzwischenschicht (200) vorsieht.

19. Verfahren nach Anspruch 1, dadurch gekennzeichnet, daß es die folgenden Schritte aufweist:
- einen ersten Schritt der Herstellung wenigstens eines Bandes (2) aus dielektrischen Material auf dem Substrat (1);
- einen zweiten Schritt des Überziehens dieser Bänder (2) mit einem Halbleiterzwischenmaterial (200), das bezüglich der anderen Materialien eine chemische Angriffsselektivität aufweist;
- einen dritten Schritt des Überziehens der so erhaltenen Einheit mit einem einkapselnden Material (300), das eine chemische Angriffsselektivität bezüglich der angrenzenden Schichten aufweist und weder eine Nukleation noch eine Abscheidung ausgehend von den Spezies der Dampfphase an seiner der Dampfphase ausgesetzten Fläche zuläßt;
- einen vierten Schritt der Herstellung von Öffnungen in dem einkapselnden Material (300) über dem Band (2) aus dielektrischem Material;
- einen fünften Schritt der Beseitigung des Halbleiterzwischenmaterials (200) durch die Öffnungen (301);
- einen sechsten Schritt des selektiven Wachstums und der selektiven Epitaxie eines monokristallinen Halbleitermaterials durch die Öffnungen (301).

20. Verfahren nach einem der Ansprüche 1 bis 5, dadurch gekennzeichnet, daß es dann die Herstellung wenigstens eines Hohlraums (3000) mit begrenztem Volumen aus einem von dem Halbleitermaterial unterschiedlichen Material aufweist, der mit einer bereits realisierten Schicht (30) aus Halbleitermaterial in Verbindung steht, so daß wenigstens ein weiteres Wachstum einer dünnen monokristallinen Schicht eines Halbleitermaterials ausgehend von der bereits hergestellten Schicht (30) aus Halbleitermaterial realisiert wird.

21. Verfahren nach Anspruch 14, dadurch gekennzeichnet, daß das Zwischenmaterial (101, 102) organisch ist.

22. Verfahren nach Anspruch 21, dadurch gekennzeichnet, daß das Zwischenmaterial (101, 102) ein Polyimid oder ein Polymer ist.

23. Verfahren nach Anspruch 14, dadurch gekennzeichnet, daß das Zwischenmaterial mineralisch ist.
